# EUROPEAN PATENT SPECIFICATION

(11) **EP 1 230 664 B1**
(45) Date of publication and mention of the grant of the patent: **07.05.2008**
(21) Application number: 00978613.8
(22) Date of filing: 14.11.2000
(51) Int. Cl.: H01J 37/32

(54) **PROCESSING SYSTEMS**
BEHANDLUNGSVORRICHTUNGEN
SYSTEMES DE TRAITEMENT

(30) Priority: 15.11.1999 US 440794
(43) Date of publication of application: 14.08.2002
(73) Proprietor: LAM RESEARCH CORPORATION, Fremont, CA 94538-6516 (US)
(72) Inventor: BAILEY, Andrew, D., III, Pleasanton, CA 94566 (US); SCHOEPP, Alan, M., Ben Lomond, CA 95005 (US); HEMKER, David, J., San Jose, CA 95127 (US); WILCOXSON, Mark, H., Piedmont, CA 94611 (US)
(74) Representative: Browne, Robin Forsythe
(86) International application number: PCT/US2000/031229
(87) International publication number: WO 2001/037314

(56) References cited:
- EP-A- 0 821 397
- WO-A-99/50886
- US-A- 5 810 932
- PATENT ABSTRACTS OF JAPAN vol. 018, no. 033 (E-1493), 18 January 1994 (1994-01-18) & JP 05 267237 A (NIPPON TELEGR & TELEPH CORP), 15 October 1993 (1993-10-15)
- PATENT ABSTRACTS OF JAPAN vol. 1999, no. 07, 31 March 1999 (1999-03-31) & JP 09 139380 A (APPLIED MATERIALS INC), 27 May 1997 (1997-05-27) & US 6 022 446 A (DING JI ET AL) 8 February 2000 (2000-02-08)

## Description

The present invention relates to apparatus and methods for processing substrates such as semiconductor substrates for use in IC fabrication or panels (e.g., glass, plastic, or the like) for use in flat panel display applications. More particularly, the present invention relates to improved plasma processing systems that are capable of processing substrates with a high degree of processing uniformity across the substrate surface.

Plasma processing systems have been around for some time. Over the years, plasma processing systems utilizing inductively coupled plasma sources, electron cyclotron resonance (ECR) sources, capacitive sources, and the like, have been introduced and employed to various degrees to process semiconductor substrates and display panels.

In a typical plasma processing application, the processing source gases (such as the etchant gases or the deposition source gases) are introduced into the chamber. Energy is then provided to ignite a plasma in the processing source gases. After the plasma is ignited, it is sustained with additional energy, which may be coupled to the plasma in various well-known ways, e.g., capacitively, inductively, through microwave, and the like. The plasma is then employed in the processing task, e.g., to selectively etch or deposit a film on the substrate. Plasma processing systems in general are well known in the art and the reference literature is replete with details pertaining to various commercially available systems. Thus general principles pertaining to plasma processing will not be discussed in great detail here for brevity's sake.

In processing the substrates, one of the important parameters that process engineers strive to improve is processing uniformity. In the etch environment, for example, etch uniformity is an important determinant of yield, i.e., a high level of etch uniformity tends to improve the percentage of defect-free processed substrates, which translates into lower cost for the manufacturer. As the term is employed herein, etch uniformity refers to the uniformity of the entire etch process across the substrate surface including etch rate, microloading, mask selectivity, underlayer selectivity, critical dimension control, and profile characteristics like sidewall angle and roughness. If the etch is highly uniform, for example, it is expected that the etch rates at different points on the substrate tend to be substantially equal. In this case, it is less likely that one area of the substrate will be unduly over-etched while other areas remain inadequately etched. In addition, in many applications these stringent processing requirements may be contradictory at different stages during the substrate processing. Often this is due to the presence of multiple films that must be processed with dramatically different plasma processing requirements. For example, the gas pressure, plasma density and chemistry may be required to dramatically change while processing a single substrate to achieve the desired processing performance.

In addition to processing uniformity, there also exist other issues of concern to the process engineers. Among the important issues to manufacturers is the cost of ownership of the processing tool, which includes, for example, the cost of acquiring and maintaining the system, the frequency of chamber cleaning required to maintain an acceptable level of processing performance, the longevity of the system components, and the like. Thus a desirable etch process is often one that strikes the right balance between the different cost-of-ownership and process parameters in such a way that results in a higher quality process at a lower cost. Further, as the features on the substrate become smaller and the process becomes more demanding (e.g., smaller critical dimensions, higher aspect ratios, faster throughput, and the like), process engineers are constantly searching for new methods and apparatuses to achieve higher quality processing results at lower costs.

EP-A-0821397 discloses a plasma reactor composed of bulk SiC with a CVD SiC film surface layer.

### SUMMARY OF THE INVENTION

The invention relates to a plasma processing system for processing a substrate according to claim 1, which includes a single chamber, substantially azimuthally symmetric plasma processing chamber within which a plasma is both ignited and sustained for the processing. The plasma processing chamber has no separate plasma generation chamber. The plasma processing chamber has an upper end and a lower end. The plasma processing chamber includes a material that does not substantially react with the reactive gas chemistries that are delivered into the plasma processing chamber. In addition, the reactant gases that are flown into the plasma processing chamber are disclosed.

The plasma processing system includes a coupling window disposed at an upper end of the plasma processing chamber and an RF antenna arrangement disposed above a plane defined by the substrate when the substrate is disposed within the plasma processing chamber for the processing. The plasma processing system also includes an electromagnet arrangement disposed above the plane defined by the substrate. The electromagnet arrangement is configured so as to result in a radial variation in the controllable magnetic field within the plasma processing chamber in the region proximate the coupling window and antenna when at least one direct current is supplied to the electromagnet arrangement. The radial variation is effective to affect processing uniformity across the substrate.

The plasma processing system additionally includes a dc power supply coupled to the electromagnet arrangement. The dc power supply has a controller to vary a magnitude of at least one direct current, thereby changing the radial variation in the controllable magnetic field within the plasma processing chamber in the region proximate the antenna to improve the processing uniformity across the substrate.

The invention also relates to a method for controlling processing uniformity while processing a substrate using a plasma-enhanced process. The method includes providing a plasma processing chamber having a single chamber, substantially azimuthally symmetric configuration within which a plasma is both ignited and sustained during the processing of the substrate, the plasma processing chamber having no separate plasma generation chamber. The plasma processing chamber includes a material that does not substantially react with the reactive gas chemistries that are delivered into the plasma processing chamber. In addition, the reactant gases that are flown into the plasma processing chamber are disclosed

The method also includes providing a coupling window disposed at an upper end of the plasma processing system and providing an RF antenna arrangement disposed above a plane defined by the substrate when the substrate is disposed within the plasma processing chamber for the processing. The method additionally includes providing an electromagnet arrangement disposed above the plane defined by the substrate. The electromagnet arrangement is configured so as to result in a radial variation in the controllable magnetic field within the plasma processing chamber in the region proximate the coupling window and antenna when at least one direct current is supplied to the electromagnet arrangement. The radial variation is effective to affect processing uniformity across the substrate.

Additionally, there is included providing a dc power supply coupled to the electromagnet arrangement, placing the substrate into the plasma processing chamber, flowing reactant gases into the plasma processing chamber, striking the plasma out of the reactant gases, and changing the radial variation in the controllable magnetic field within the plasma processing chamber in the region proximate the antenna to improve the process uniformity across the substrate.

In yet another embodiment, the invention relates to a plasma processing system for processing a substrate, which includes a single chamber, substantially azimuthally symmetric plasma processing chamber within which a plasma is both ignited and sustained for the processing. The plasma processing chamber has no separate plasma generation chamber. The plasma processing chamber has an upper end and a lower end.

The plasma processing system includes a coupling window disposed at an upper end of the plasma processing chamber, and an RF antenna arrangement disposed above a plane defined by the substrate when the substrate is disposed within the plasma processing chamber for the processing.

There is further included a first RF power supply coupled to the RF antenna, and a first magnet arrangement disposed above the plane defined by the substrate. The magnet arrangement is configured so as to result in a radial variation in the controllable magnetic field within the plasma processing chamber in the region proximate the coupling window and antenna due to magnetic field lines emanating from the magnet arrangement. The radial variation is effective to affect processing uniformity across the substrate.

Additionally, there is included a substrate support arrangement configured to support the substrate within the plasma processing chamber during the processing, and a second RF power supply coupled to the substrate support arrangement. The second RF power supply is controllable independently from the first RF power supply. Further, there is included means to vary the radial variation in the controllable magnetic field within the plasma processing chamber in the region proximate the antenna to improve the processing uniformity across the substrate.

These and other features of the present invention will be described in more detail below in the detailed description of the invention and in conjunction with the following figures.

### BRIEF DESCRIPTION OF THE DRAWINGS

The present invention is illustrated by way of example, and not by way of limitation,
in which:
Fig. 1 illustrates, in accordance with one embodiment of the present invention, a plasma processing system, including an exemplary RF antenna arrangement and an exemplary upper magnet arrangement.
Fig. 2A shows some exemplary magnetic field lines that may be created within the chamber of Fig. 1 to facilitate a radial variation in the controllable magnetic field strength and topology within the plasma processing chamber.
Fig. 2C shows a typical topography of the radial variation in the controllable magnetic field strength.

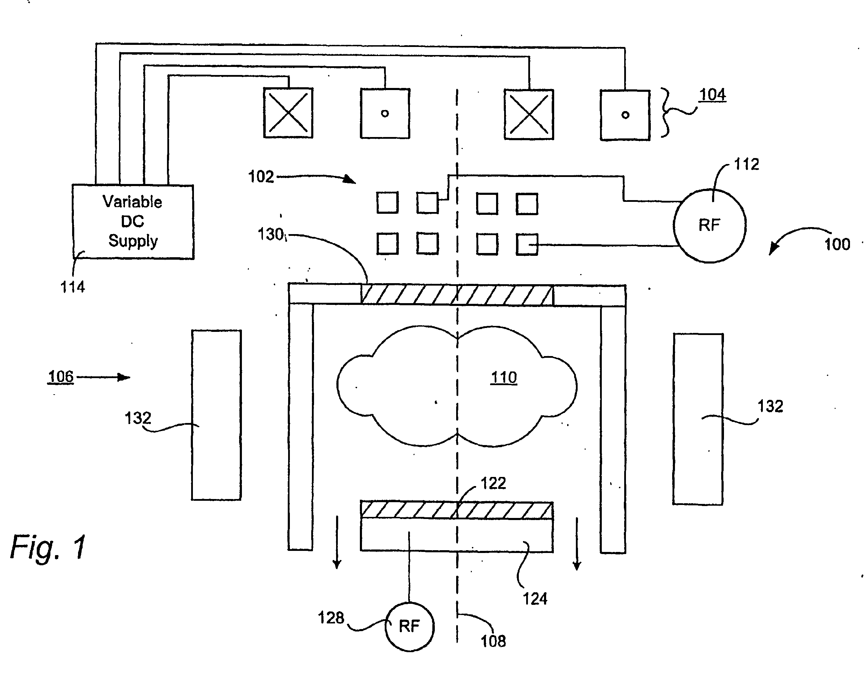

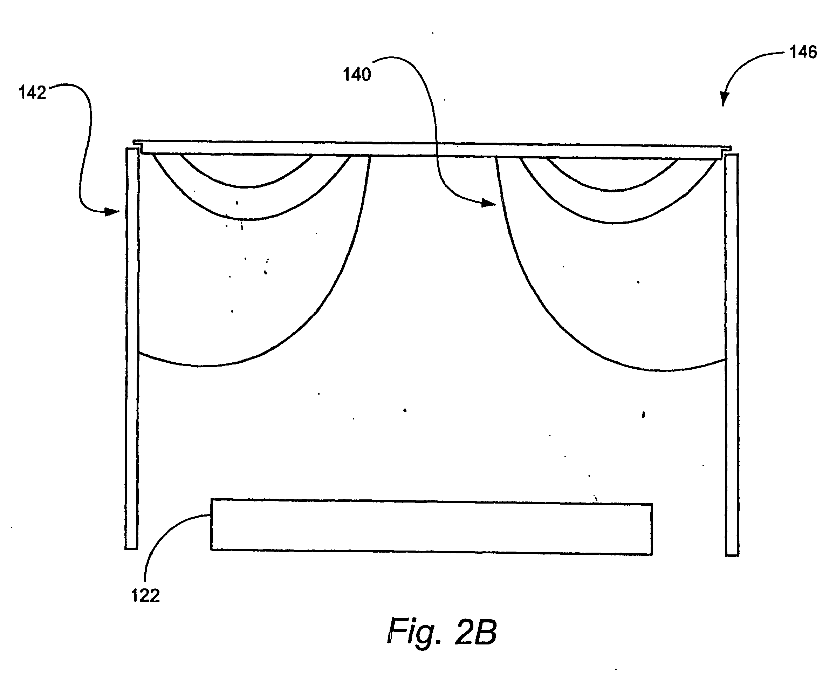

Fig. 2B is an exemplary illustration of another radially divergent magnetic field topology that may be generated when the dc currents in the electromagnet coils of the plasma processing system of Fig. 1 are manipulated.

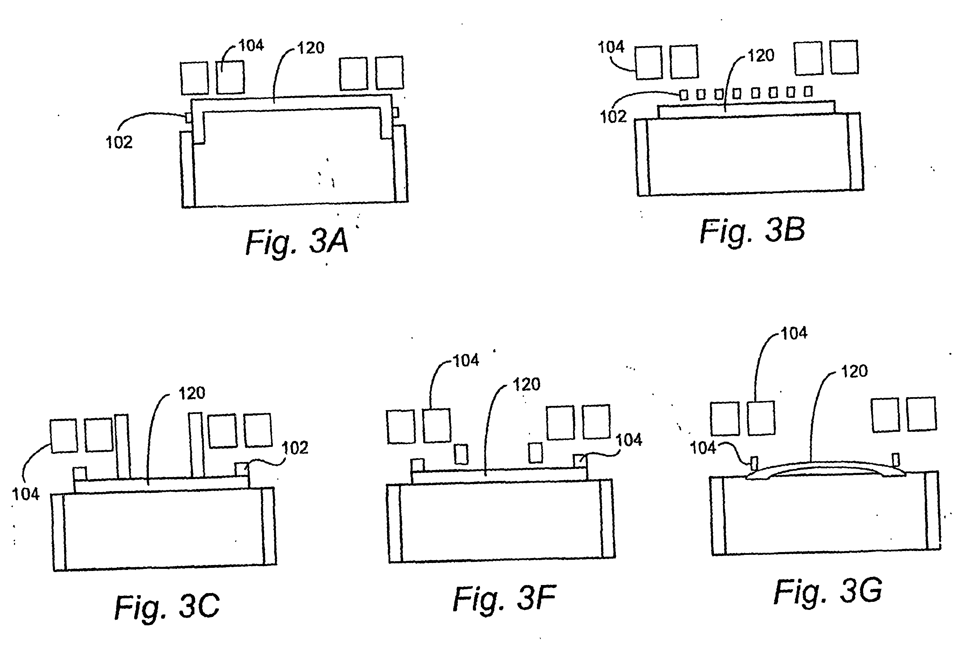

Figs. 3A-3H show various RF antenna arrangements that may be employed with the inventive plasma processing system, in accordance with embodiments of the present invention

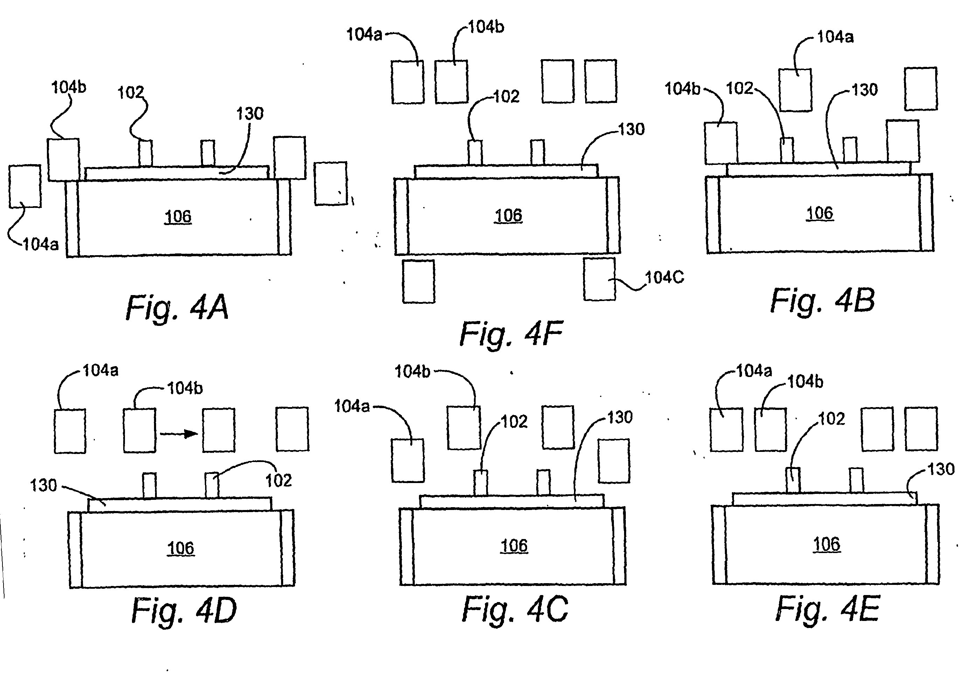

Fig. 4A-4F show various magnet field generator arrangements that may be employed with the inventive plasma processing system, in accordance with embodiments of the present invention.

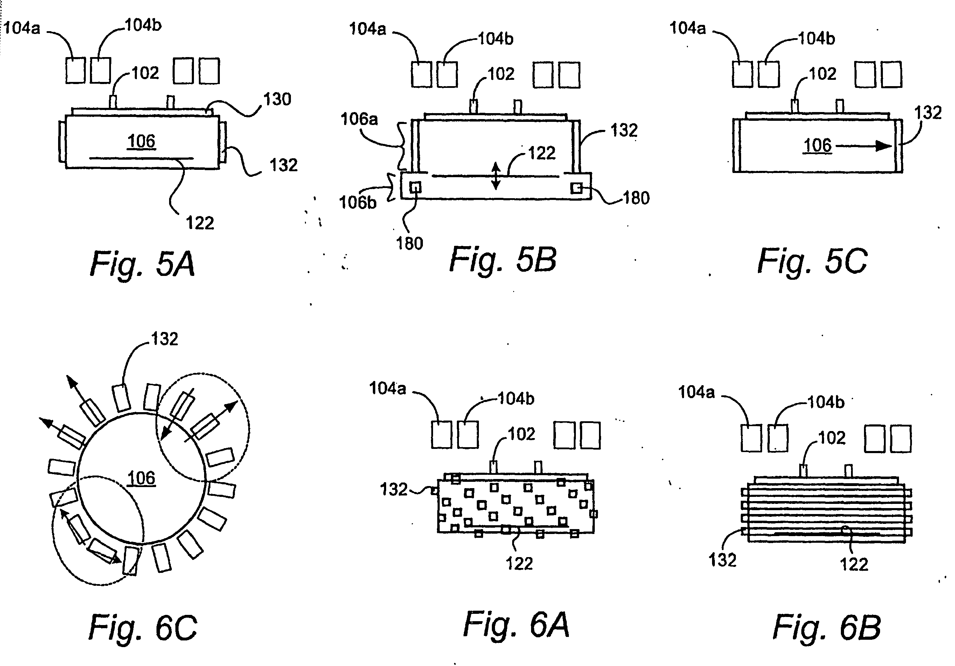

Figs. 5A-5C show various magnetic bucket arrangements that may be employed with the inventive plasma processing system, in accordance with embodiments of the present invention.
Figs. 6A-6C show various magnetization patterns that may be employed with the inventive plasma processing system, in accordance with embodiments of the present invention.

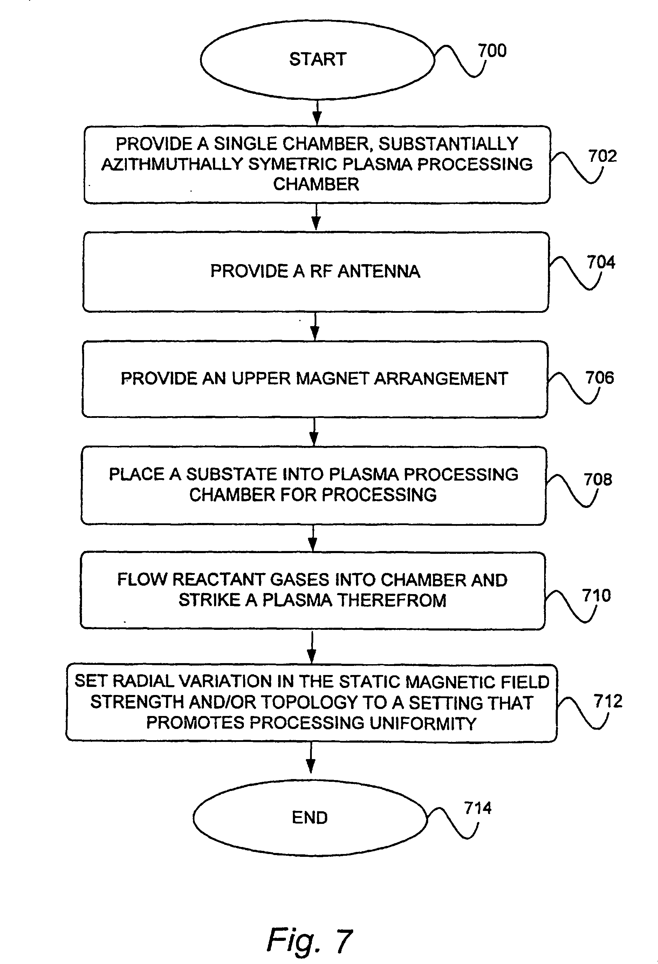

Fig. 7 illustrates, in accordance with one embodiment of the present invention, a simplified flowchart illustrating the steps involved in controlling process uniformity by altering the radial variation of the controllable magnetic field strength and/or topology.

### DETAILED DESCRIPTION OF THE PREFERRED EMBODIMENTS

The present invention will now be described in detail with reference to a few preferred embodiments thereof as illustrated in the accompanying drawings. In the following description, numerous specific details are set forth in order to provide a thorough understanding of the present invention. It will be apparent, however, to one skilled in the art, that the present invention may be practiced without some or all of these specific details. In other instances, well known process steps and/or structures have not been described in detail in order to not unnecessarily obscure the present invention.

The invention relates, in one embodiment, to an improved plasma processing system that is capable of a high degree of processing uniformity control. The exemplary improved plasma processing system includes a single chamber, substantially azimuthally symmetric, i.e., each cross section parallel to the wafer plane has a nearly circular shape, plasma processing chamber that is employed to both generate the plasma and to contain the plasma for the processing task. The improved plasma processing system further includes an upper magnet arrangement and an RF antenna arrangement disposed above the plane of the substrate during processing.

The RF antenna arrangement and the upper magnet arrangement are arranged such that there would be a nontrivial amount of radial variation in the controllable magnetic field strength and topology within the plasma processing chamber sufficiently far above the substrate that the induced variation in processing uniformity is achieved while simultaneously ensuring the magnetic field strength at the substrate is low. In the preferred embodiment, this radial variation in the controllable magnetic field strength and topology is primarily in the vicinity of the region of power coupling near the RF antennae /vacuum interface. The radial variation in the controllable magnetic field strength and topology is such that it affects the processing uniformity in a nontrivial way. By purposefully designing a plasma processing system to create a pattern of radial variation in the controllable magnetic field strength and topology that is capable of affecting processing uniformity, and then providing a way to vary that radial variation, a uniformity dial is provided to allow process engineers to tune the process so as to improve uniformity.

In one example, the aforementioned radial variation in the controllable magnetic field strength and topology is created by making the RF antenna arrangement non-coplanar with the upper magnet arrangement. Alternatively or additionally, the radial variation in the controllable magnetic field strength and topology may be created by providing an upper magnet arrangement that includes two or more electromagnet coils, which may be coplanar or non-coplanar relative to each other. The multiple electromagnet coils may be (but not required to be) furnished with dc currents having opposite directions to induce the aforementioned radial variation in the controllable magnetic field strength and topology.

For ease of manufacturing and simplicity of operation, the plasma processing chamber is preferably configured (though not restricted to) to be a single chamber, substantially azithmuthally symmetric plasma processing chamber. In other words, the plasma processing chamber of the present invention preferably consists of a single chamber that both generates and contains the plasma for substrate processing (and therefore eliminates the need for a separate chamber for plasma generation), and also is substantially azithmuthally symmetric to promote uniformity. By way of example and not by way of limitation, the chamber may assume the shape of single cylindrical or dome-shaped chamber.

In a preferred embodiment, the chamber assumes the shape of a single cylindrical chamber wherein the plasma is both ignited and contained for the processing task without the requiring the use of a separate chamber for plasma generation and a separate chamber for processing.

In one exemplary improved plasma processing system, there is further provided a magnetic bucket arrangement that is configured to force a substantial number of the plasma density gradients to occur away from the substrate. In one preferred embodiment, the magnetic bucket arrangement is disposed about the periphery of the plasma processing chamber. Preferably but not necessarily, the magnetic bucket arrangement includes a plurality of permanent magnets that are axially oriented about the periphery of the plasma processing chamber, either inside or outside of the chamber walls. Irrespective of the specific implementation, the magnetic bucket arrangement is configured to force the plasma density gradients to concentrate near the chamber walls away from the substrate. In this manner, uniformity is further enhanced as the plasma density gradient change across the substrate is minimized or substantially reduced In combination with the aforementioned controllable radial variation of magnetic field strength and topology, process uniformity is improved to a much greater degree in the improved plasma processing system than is possible in many existing plasma processing systems.

The magnetic bucket tends to reduce the plasma losses to the wall, hence the exemplary improved plasma processing system may more efficiently use the plasma created by the source. Accordingly, for a given source power, more density can generally be achieved than in typical processing systems, which in turn offers a wider processing window. In many cases the desired processing density may be easily achieved, yet in the exemplary improved system, less source power is typically required to generate the density. As can be appreciated by those skilled in the art, the lower setting of the source power tends to reduce possible wafer damage mechanisms and further widens the allowed processing window of the system.

Plasma analyses of reactors (such as those based on volume ionization balanced by Bohm losses to the walls) also predict that the electron temperature for a given power deposition will be reduced by reducing the plasma loss area. This is accomplished, in one embodiment, by incorporating the magnetic bucket. Such a reduction in electron temperature generally leads to lower potentials on and across the wafer that could cause damage to the electronic circuits being processed. Eliminating this root cause of plasma induced damage tends to significantly enhance the operating window of the tool.

It has also been observed that in some depositing plasma chemistries, the bucket fields tend to reduce the total polymer deposition on the walls thereby reducing the chamber clean times expected from the increased surface areas required in chambers suitable for increasingly large wafers.

The average density across the wafer also may play a large role in determining the resulting process result. By reducing the plasma loss to the walls using the magnetic bucket, the uniformity control mechanism disclosed here is substantially independent of the average density.

In addition, the disclosed uniformity control invention is facilitated by a very low magnetic field at the wafer, which is preferentially achieved by locating the higher magnetic field regions away from the wafer. Using the magnetic bucket to efficiently use the density created by the source is thus very beneficial.

The features and advantages of the present invention may be better understood with reference to the figures and discussions that follow. Fig. 1 illustrates, in accordance with one embodiment of the present invention, a plasma processing system 100, including an exemplary RF antenna arrangement 102 and an exemplary upper magnet arrangement 104. In the example of Fig. 1, RF antenna arrangement 102 and upper magnet arrangement 104 are shown disposed above a plasma processing chamber 106. As will be discussed later herein, other positions are also possible for RF antenna arrangement 102 and upper magnet arrangement 104.

RF antenna arrangement 102 is shown coupled to an RF power supply 112, which may supply RF antenna arrangement 102 with RF energy having a frequency in the range of about 0.4 MHz to about 50 MHz. More preferably, the frequency range is about I MHz to about 30 MHz. In the preferred embodiment for etching, the RF frequency supplied to RF antenna arrangement 102 is preferably about 4 MHz.

Upper magnet arrangement 104 of the embodiment of Fig. 1 includes two concentric magnetic coils, both of which carry dc currents running in opposite directions. Upper magnet arrangement 104 is shown coupled to a variable direct current power supply 114, which is configured to vary the magnitude and/or direction of the direct current(s) supplied to the electromagnet coil(s) of upper magnet arrangement 104 to vary the radial variation in the controllable magnetic field strength and topology in region 110 to achieve the desired level of processing uniformity across the substrate surface for a given process.

A substrate 122 is shown disposed above a substrate support arrangement 124, which is coupled to a bias RF power supply system 128 to independently control the energies of the charged particles impinging on the wafer. Bias RF power supply 128 may supply RF energy having a periodic, but not necessarily sinusoidal, frequency range of about 0.3 MHz to about 50 MHz, more preferably about 2 MHz to about 30 MHz, and preferably at about 13.5 MHz. Substrate 122 represents the workpiece to be processed, which may represent, for example, a semiconductor substrate to be etched, deposited, or otherwise processed or a display panel to be processed into a flat panel display. Preferably in one embodiment utilizing the magnetic bucket, but not absolutely necessary, the substrate should be supported well inside the lowest portion of the magnetic bucket to avoid any axial gradients in the plasma processing mixture that may occur to the proximity of the changing level of confinement provided at the transition from the magnetic bucket portion to a non-magnetic portion. Manufacturing and cost aspects may determine the actual extent of the magnetic bucket and relative location of the substrate during processing.

As shown in Fig. 1, plasma processing chamber 106 is shown to have a simple generally cylindrical shape. In other words, the portion of the plasma processing chamber 106 that is employed to both ignite and sustain a plasma for processing the substrate preferably consists of a single chamber though the techniques discussed could be implemented into a multi-chamber reactor. Advantageously, there is no need for a separate plasma generation chamber, which complicates the manufacturability of the chamber and introduces additional plasma transport issues (e.g., necessitating a mechanism to properly transport the generated plasma out of the plasma generation chamber and into the processing chamber for processing the substrate). Also, the substantially vertical sidewalls of the chamber above the substrate and the simple cylindrical shape renders the chamber walls more easily manufactured, less susceptible to deposition of particulate matters which may flake off eventually to contaminate the substrate, and simplifies chamber cleaning issues. It is envisioned that some curvature in the walls, although complicating the design of the reactor, may also be used and may have further advantages regarding chamber cleaning and handling. The exact design and shape of the single chamber, substantially azithmuthally symmetric plasma processing chamber may depend on a balance between cost, ease of service and manufacturability for a particular manufacturer.

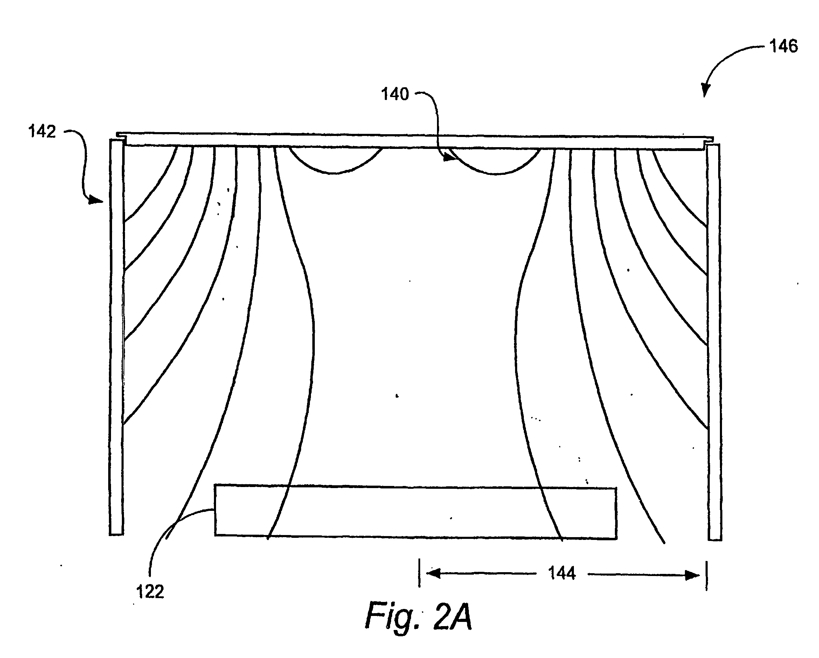

In the drawing of Fig. 1, RF antenna arrangement 102 and upper magnet arrangement 104 are non-coplanar, i.e., they are offset spatially along the axis 108 of the plasma processing chamber so as to induce a radial variation in the controllable magnetic field strength and topology within the plasma processing chamber in the region 110 proximate RF antenna, coupling window/vacuum interface arrangement 102. Fig. 2A shows some exemplary magnetic field lines that may be created within chamber 106 of Fig. 1 to facilitate a radial variation in the controllable magnetic field strength and topology within the plasma processing chamber.

Advantageously, there is now a nontrivial radial variation in the controllable magnetic field strength and topology, which is purposefully created in the improved plasma processing system and purposefully configured to be capable of having a nontrivial effect on the processing uniformity at the substrate surface. For example the field lines 140 in Fig. 2A are shown diverging from an annulus of high magnetic field strength with a radius near half the radius 144 of the chamber 146. By providing a mechanism for varying this purposefully created radial variation in the controllable magnetic field strength and topology, the process uniformity across the substrate surface can be fine tuned to a greater degree than possible in prior art plasma processing systems

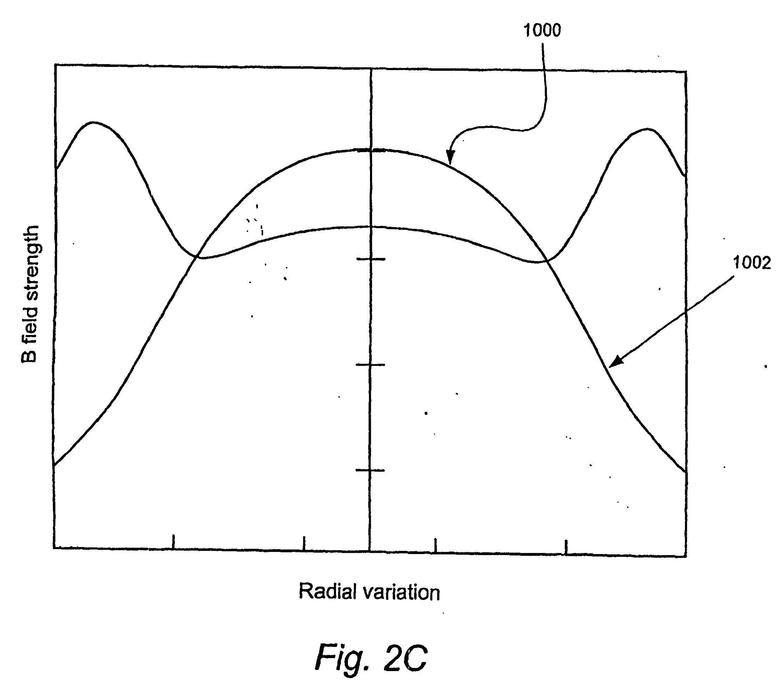

The range of B fields from the B coils are about 0 to about 1.5 Tesla (1,500 Gauss), more preferably about 0 to about 0.2 Tesla (200 Gauss) or optimally about 0 to about 0.005 Tesla (50Gauss) as measured near the window/vacuum interface. Fig. 2B is an exemplary illustration of another radially divergent magnetic field topology that may be generated when the dc currents in the electromagnet coils 104 of Fig. 1 are manipulated. For example in Fig. 2B the field lines diverge from a high field region on axis as compared to those in Fig. 1. The exact topology of closed and open flux lines is controllable using coils 104 of Fig. 1. Additionally, the range of variation and absolute magnitude of the angle of said field lines is determined by the exact design of the magnetic coils. For example the magnets may be made non-coplanar to provide an example of field lines pointing more towards the axis than those shown in Fig. 1. The optimal b-coil design is interdependent on the chamber diameter, presence and strength of the magnetic bucket, the antenna and plasma processing regimes for which the reactor is designed. The design can be determined in accordance with principles of the present invention. Typical topographies of radial variation are shown in Fig 2C. The B field strength in case 1000 has a single local maximum on axis whereas in case 1002 there are two symmetrically positioned local maxima at finite radius and also a local maxima on axis. In the present invention these types of variations in topography can be controlled using the electromagnet assembly.

There is also shown in Fig. 1 a magnetic bucket arrangement 132, which includes a plurality of permanent magnets axially oriented around the periphery of the plasma processing chamber. As mentioned, magnetic bucket arrangement 132 is configured to keep the plasma density gradient away from the substrate while simultaneously maintaining a very small magnetic field at the wafer. In the exemplary embodiment of Fig. 1, magnetic bucket arrangement 132 includes 32 permanent magnet cusps that have their radial magnetization factors alternating around the chamber (e.g., N,S,N,S, etc.). However, the actual of number of cusps per chamber may vary according to the specific design of each plasma processing system.

In general, the number of cusps should be sufficiently high to ensure that there is a strong plasma density gradient away from the substrate. However as the losses are, relative to the rest of the chamber bucket, highest at the cusp, too many cusps may degrade the density enhancement. By way of example, a magnetic field strength of about 0.0015 to 1.5 Tesla (15-1,500 Gauss) at the vacuum-wall interface may be suitable for some processes. More preferably, the magnetic field strength at the vacuum-wall interface may be between about 0.01 Tesla (100 Gauss) and about 0.1 Tesla (1,000 Gauss). Preferably, the magnetic field strength at the vacuum-wall interface may be about 0.08 Tesla (800 Gauss). It should be understood that the use of magnetic bucket arrangement 102 enhances the plasma uniformity across the wafer surface and may not be required for all processes. However, if a high degree of uniformity is critical, the inclusion of a magnetic bucket arrangement can be quite beneficial.

In the preferred embodiments, the RF antenna arrangement is preferably disposed above the RF coupling window to advantageously simplify the design and construction of the chamber and/or the RF coupling window and/or the magnetic bucket arrangement. However, it is contemplated that the desired controllable radial variation in magnetic field strength and topology may also be achieved by placing the RF antenna arrangement in other positions on the chamber. By way of example, Fig. 3A shows a plasma processing system designed in accordance with principles of the present invention that has a RF antenna arrangement 102 disposed around the periphery of a coupling window 120. It is preferable, however, to position the RF antenna arrangement so that it is above the plane formed by the substrate when the substrate is disposed within the plasma processing chamber for processing. Further, the RF antenna should be sufficiently close to the upper magnet arrangement to facilitate the formation of a plasma in proximity to the higher B field strength region of controllable radial variation in B field strength and topology.

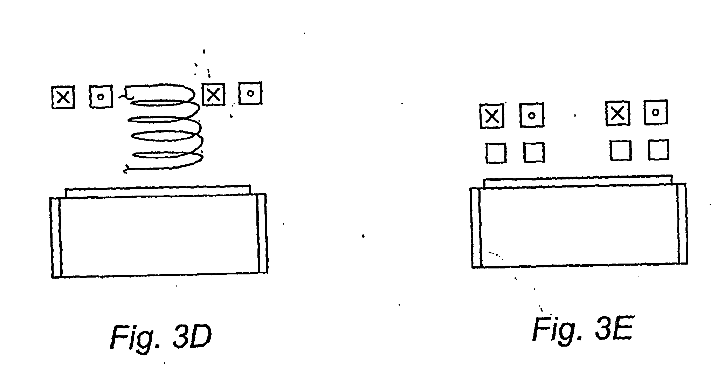

In the exemplary embodiment of Fig. 1, a RF antenna having a 3-D, stacked configuration is employed to promote azithmuthally symmetric coupling, which is important when a high level of processing uniformity across the substrate is desired. It should further be noted, however, that this 3-D, stacked configuration is not required in all cases. In many cases, the inherent azithmuthal symmetric coupling characteristic of such an antenna is not a necessity (e.g., in cases where acceptable uniformity is already achievable with antennas that do not have an inherent azithmuthal symmetric coupling characteristic such as a planar spiral antenna). Examples of alternative RF antenna arrangements that may be employed may be seen in Fig. 3B (planar spiral coil), Fig. 3C (RF antenna coil having different number of loops, each of which may have a different thickness), Fig. 3D (RF antenna coil having different number of loops arranged vertically), Fig. 3E (RF coupling source comprising multiple individually driven antennas), and Fig. 3F (domed antenna, which may be a single coil as shown or may involve multiple coils driven together or with a plurality of independent supplies). Further, the RF antenna arrangement may have other non-axis encircling configuration of different types such as D-shape, multiple antennas, and the like.

With respect to the RF frequency employed, as a general guideline, a lower RF frequency, e.g., <13 MHz with typical dielectric constants and physical dimensions found on these tools, tends to make any inherent azimuthally asymmetric coupling characteristic of an antenna less pronounced. Accordingly, a wider array of antenna configurations may be employed at a lower RF frequency. By way of example, a planar spiral antenna may be employed to achieve high quality etches in the improved plasma processing chamber when the RF frequency is low, e.g., 4MHz. At a relatively high RF frequency, e.g., 13 MHz and above, the inherent azithmuthally asymmetric coupling characteristic of an antenna can become more pronounced and can affect the process uniformity in a negative way. Accordingly, antennas that are inherently azithmuthally asymmetric in their coupling characteristics (e.g., simple spiral antennas) may be unsuitable for some processes that require a high level of process uniformity. In these cases, the use of antennas that have inherent azithmuthally symmetric coupling characteristics may be warranted.

In the preferred embodiment, the RF antenna arrangement is preferably co-axial with both the electromagnetic coils, the plasma processing chamber, and the substrate. However, such is not an absolute requirement. For some processes that may not need a high degree of process uniformity provided by the co-axial RF antenna arrangement or in chambers that employ asymmetric pumping, the RF antenna arrangement may be offset from this co-axial configuration to address the asymmetry in the chamber design. However, the purposeful introduction of the controllable radial variation controllable magnetic field strength and topology and the ability to control such radial variation in controllable magnetic field strength and topology to fine tune process uniformity across the substrate surface is still desirable.

With respect to the size of the RF antenna arrangement, it is generally preferable (but not absolutely necessary) to size the RF antenna arrangement to be smaller than the cross-section of the chamber in order to keep the plasma concentrated in the region above the substrate and to prevent undue plasma diffusion to the chamber walls, which disadvantageously require more power to operate the plasma processing system and increases wall erosion. In the exemplary improved plasma processing system of Fig. 1 wherein the magnetic bucket arrangement is disposed outside of the chamber, the footprint of the RF antenna arrangement is preferably kept inside the region defined by the magnetic bucket arrangement to reduce plasma diffusion to the chamber walls. If the magnetic bucket arrangement is disposed within the chamber interior (in the form of either a plurality of magnet structures proximate the interior walls or a magnetic structure located near the substrate axis to push the plasma density gradient toward the chamber walls), the footprint of the RF antenna arrangement is preferably kept inside the high plasma density gradient region that is proximate the chamber walls.

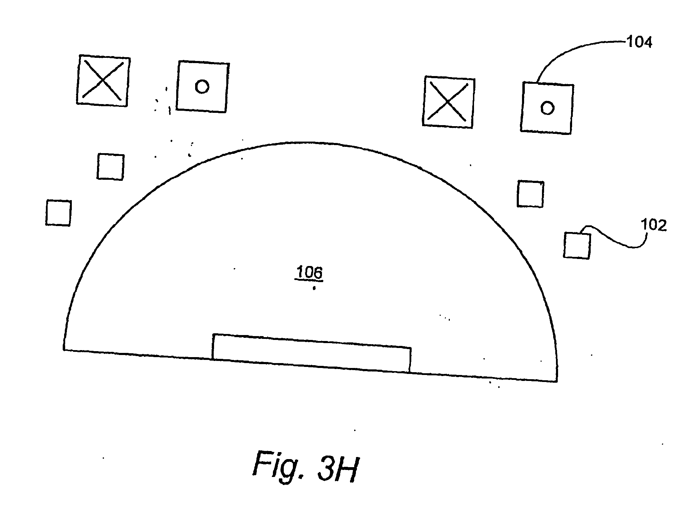

In Fig. 1, the RF coupling window is shown to be planar. However, it is contemplated that the RF coupling window may also have other shapes, such as in the exemplary Fig. 3A wherein the coupling window material also extends downward to form a cap or in the exemplary Fig. 3G wherein the window is donned. Fig. 3H shows a combination of the domed window with domed antenna. Note that there is no requirement that the radius of the RF coupling window be equal to the radius of the plasma processing chamber.

At a lower RF frequency (e.g., less than about 13 MHz), the capacitive coupling between the antenna and the plasma is reduced, which reduces bombardment of the coupling window 130. With reduced bombardment, it is possible to eliminate the requirement of a semiconductor window or the use of a Faraday shield. In fact, it is contemplated that coupling window 130 may advantageously be formed from either a dielectric material such as SiC or AlxNy or SixNy, which may also be bonded with SiC to render the coupling window more compatible with the plasma environment within the chamber.

Fig. 1 also shows an upper magnet arrangement that includes two concentric electromagnetic coils. It should be noted, however, that more than two electromagnet coils may also be provided, particularly if a fine level of uniformity control is desired. Although this multi-coil configuration is advantageous in that it is capable of creating the desired radial variation in controllable magnetic field strength and topology even when the electromagnetic coil arrangement and the RF antenna arrangement are coplanar, such is not an absolute necessity. As mentioned, such radial variation in controllable magnetic field strength and topology may also be obtained when the electromagnetic coil arrangement and the RF antenna arrangement are non-coplanar along the axis of the chamber irrespective of the number of coils involved.

In general, the radially divergent magnetic field topology may be varied by changing the magnitude and/or direction of the dc current(s) that is/are supplied to the electromagnet coil(s). If there are multiple electromagnet coils involved, as is the case in the example of Fig. 1, the magnitude and/or direction of one or more of the direct currents supplied to the multiple electromagnet coils involved may be manipulated to have the desired uniformity effect on the substrate surface. Of course the radial variation in the controllable magnetic field strength and topology may also be manipulated in other ways. By way of example, the radially varying magnetic field topology may also be varied by physically moving the upper magnet arrangement, either by rotating it about an axis different from 108, moving it along the chamber axis, moving it in the same plane and/or tilting the upper magnet arrangement. As a further example, the introduction and movement of a magnetic flux plate material around the magnetic coils may also adjust the field topology.

Since uniformity control is facilitated by manipulating the radial variation of the magnetic field strength and topology that is generated primarily in the vicinity of region 110 near RF antenna arrangement 102, the distance between the substrate and the upper magnet arrangement is an important parameter. This is because changes to the radial component of the magnetic field topology also impact the axial component. Preferably, the magnetic field strength while processing the substrate should be fairly weak (e.g., less than about 0.00015 Tesla (15 Gauss)) at the substrate surface and strong at axial positions near the RF antenna arrangement (e.g., about 0.00015 Tesla (15 Gauss) to about 0.02 Tesla (200 Gauss) near the vacuum-window interface). If the field strength becomes too low in too large a volume adjacent to the wafer, the plasma will nearly approach the diffusion profile obtainable without the uniformity control mechanism in place. Although such a diffusion profile may be sufficiently uniform for some areas within the reactor's designed processing window, the advantages associated with having a controllable radial variation in the magnetic field strength and topology are substantially attenuated.

With these considerations in mind, the distance should be sufficiently small enough to allow processing uniformity to be manipulated when the radially varying magnetic field strength and topology is altered. However, the distance should not be unduly small so as to induce substrate damage due to variations in currents flowing in the wafer or charging of the etched features on the wafer being processed caused or enhanced by excessive the magnetic field at the wafer location during processing. In addition if the source to wafer distance is too small, the axial diffusion begins to dominate the processing uniformity. The radial variation scale length then required to control the uniformity becomes close to the size of the non-uniformity to be controlled. This leads to a less optimal magnetic design because of the increased number and required control precision of local radial variations in the magnetic field strength and topology. In other words if the chamber is too small, its physical boundaries control the processing uniformity to such an extent that the application of the principles of this invention, though still applicable, force over-complication of the design and a less optimal balance between the desired uniformity control and other real life considerations as described earlier, i.e., cost, reliability etc.

In the preferred embodiment, the distance between the substrate and the upper magnet arrangement may be determined, empirically in some cases, by taking into account the strengths of the radially divergent component and the axial component of the controllable magnetic field topology and the need to avoid undue substrate damage when dc current is furnished to the electromagnetic coil arrangement to tune the process uniformity. In one exemplary embodiment, a distance of 20 cm is appropriate for a substrate processing chamber designed for processing semiconductor substrates having a diameter of less than about 470mm.

In the embodiment of Fig. 1, the upper magnet arrangement is shown disposed above the RF coupling window. However, such is not an absolute requirement. Fig. 4A shows an implementation wherein at least one of the coils 104a is disposed around the periphery of chamber 106. The implementation of Fig. 4A also shows the use of two coils, which are also non-coplanar relative to one another. While this implementation may be suitably employed, neither requirement (multi-coil or non-coplanar) is absolutely required. Note that in Fig. 4A, the coils can be disposed above or below the window 130 as desired. However, it is preferred that the coils be disposed above the substrate plane and proximate to the RF antenna to meaningfully affect the radial variation in the magnetic field strength and topology created.

In the preferred embodiment, the upper magnet arrangement is co-axial with the antenna, the chamber, and the substrate to simplify the alignment of the plasma cloud with the substrate. However, it is contemplated that in some plasma processing chambers, e.g., those employing asymmetric pumping or those that require a more complex magnetic field topology, it may be advantageous to offset the upper magnet arrangement from the chamber axis and/or the substrate axis to improve the process results. One such implementation is shown in Fig. 4B whereas at least one of coils 104a and 104b are offset from the chamber axis. Likewise, although the magnet coils are shown to be planar, such is not an absolute necessity and it is contemplated that domed or other 3-D shaped coils, such as those shown in Fig. 4C, may be useful, e.g., to further shape the magnetic field topology within the chamber.

Additionally, there is no requirement that the coils have to directly overlie the antenna. By way of example, in the embodiment of Fig. 4D, electromagnet coil 104b is shown overlying RF antenna 402. Such is not the case, however, in the implement of Fig. 4E.

Furthermore, although the preferred implementation of the upper magnet arrangement is electromagnet coil(s), it is contemplated that a sufficiently powerful permanent magnet arrangement, e.g., one formed from NdFeB or SmCo families of magnetic material may also be employed to purposefully create the aforementioned radial divergence in the magnetic field topology. In the case of a permanent magnet implementation, the resultant radial divergence in the magnetic field topology may be changed by physically moving components of the upper magnet arrangement and/or by providing appropriate structural or magnetic circuit elements, e.g., by interposing a structure with high magnetic permeability as part of the effective magnetic circuit of the upper permanent magnet arrangement and the coupling window, to alter the magnetic field lines appropriately. Similarly, a combination of ferromagnetic elements and electromagnets can be used.

In the embodiment of Fig. 4F, an additional magnetic field generator arrangement 104C may also be placed below the plane formed by the substrate, either outside the chamber or within the chamber, to reduce the magnetic field strength and/or further compensate for remaining variation in the magnetic field strength and/or topology at the substrate surface. In this case, the potential damage to the substrate due to an overly strong axial component of the magnetic field attributable to the upper magnet arrangement may be reduced.

Although simplicity and symmetry are demonstrated in the preferred embodiment, it is anticipated similar uniformity controlling variations can also be achieved with magnetic coils which are not circular in cross section (e.g., hexagonal or square or other geometric shapes) or with axes that are not parallel to the primary system axis.

In the exemplary plasma processing system of Fig. 1, the designs of the vacuum chamber, gas pumping, bucket magnetic fields, antenna and magnet coils of the plasma processing chamber are preferably co-axial with the axis of the chamber itself, the RF antenna arrangement and the substrate. Although this implementation is particularly advantageous in that it best utilizes the inherent symmetry of the typical substrate processing and diffusion characteristics, there may be cases wherein it would be appropriate to have the vacuum chamber and magnetic design not co-axial with the axis of the chamber, the RF antenna arrangement, and/or the substrate. By way of example, some plasma processing systems may implement asymmetric pumping. In these cases, uniformity may be enhanced by designing in a certain degree of asymmetry in the vacuum chamber and/or magnetic design to correct for the asymmetry in the flow of gases through the chamber.

Furthermore, there is no requirement that the footprint of the RF antenna has to be larger than the footprint of the upper magnetic arrangement. That is, there is no requirement that the cross-section of the upper magnetic arrangement be smaller than the cross-section of the RF antenna. As long as these two are configured so as to result in a controllable radial variation in the magnetic field strength and topology within the plasma processing chamber in the vicinity of the plasma/window interface, the relative sizes of the RF antenna and the upper magnetic arrangement can be dimensioned as desired.

If a magnetic bucket arrangement is involved, as in the case of the preferred embodiment, for improving processing uniformity for some critical processes, the design of the magnetic bucket is also of importance. In general, the magnetic bucket arrangement should produce a sufficiently strong magnetic field to force most of the plasma density gradient away from the substrate and close to the chamber walls. Preferably, the magnetic field strength at the vacuum/wall interface within the plasma processing chamber should be relatively high, e.g., between 0.0015 Tesla (15 Gauss) and 1.5 Tesla (1,500 Gauss), more preferably between about 0.01 Tesla (100 Gauss) and about 0.1 Tesla (1,000 Gauss) and in one embodiment at about 0.08 Tesla (800 Gauss). However, the magnetic field strength at the center of the substrate should be kept low, e.g., less than about 0.0015 Tesla (15 Gauss) and more preferably less than about 0.0005 Tesla (5 Gauss).

Although Fig. 1 shows the magnetic bucket arrangement to include magnets that span nearly the entire height of the plasma processing chamber, such is not a requirement. By way of example, Fig. 5A shows a magnetic bucket arrangement whose magnets 132 do not span from the top of the chamber to the bottom of the chamber . In general, it is preferred that the permanent magnets are dimensioned such that the axial gradients of the magnetic field generated by the magnetic bucket arrangement are kept low at the level of the substrate surface. In one embodiment, the magnetic portion of the magnet bucket arrangement extends from above the substrate (e.g., near the top of the chamber) to a position below the substrate plane (e.g., 2.7 cm (1.5 inches) below) to minimize or to substantially reduce the axial gradients in the magnetic field lines that are generated by the magnetic bucket arrangement.

Although this implementation is highly advantageous and preferred, it is contemplated that it may be possible, for some processes, to employ a plasma processing system which has chamber magnets (i.e., the magnets of the magnetic bucket arrangement) disposed on only one side of the substrate plane. By way of example, if the process uniformity requirement can tolerate the presence of some axial gradients of the magnetic field lines generated by the magnetic bucket arrangement, it may not be necessary to require that the chamber magnets extend to both sides of the substrate plane. As another example, it may be possible to have two sets of chamber magnets, one on each side of the substrate plane (such as sets 132 and 180 in Fig. 5B), to ensure that the axial gradients of the magnetic field lines generated by the magnetic bucket arrangement is kept low at the substrate surface while forcing most of the plasma density gradients away from the substrate and close to the chamber walls. Further, although the embodiment of Fig. 1 shows the cusps of the magnetic bucket arrangement to be outside the vacuum, such is not an absolute requirement. By way of example, the second set of magnets in Fig 5B (reference numeral 180) are shown inside the vacuum.

Further, although permanent magnets are employed for implementing the magnetic bucket arrangement in the preferred embodiment, it is also possible to implement the magnetic bucket arrangement using electromagnets.

As mentioned, although one important feature of the present invention is the elimination of the plasma generation chamber, it is recognized that while the same chamber can be used to ignite, generate, and contain the plasma for processing, there is no absolute necessity to keep the substrate in the same chamber. As shown in Fig. 5B, an additional chamber 106b may be provided to house the support that holds the substrate and facilitate substrate transport. By employing a single chamber 106a to generate and sustain the plasma for the processing tasks, many of the plasma and chemistry transport issues and chamber wall adsorption issues are already resolved, and it is thus not absolutely necessary to require that the chuck arrangement and the exhaust paths also be located in the same chamber. In other words, as long as the substrate surface that undergoes processing is exposed to the plasma in the single chamber employed to both generate and sustain the plasma for processing, and there is a uniformity control knob to fine tune the radially divergent magnetic field topology, highly advantageous process results can be achieved. If a magnetic bucket arrangement is also employed to force plasma density gradients of the generated plasma away from the substrate surface and toward the walls, a highly uniform process may be achieved even if the chuck arrangement and a portion of or the entire substrate is positioned in one chamber and the substrate surface to be processed is exposed to the plasma ignited and sustained for processing in the other chamber.

Further, although the magnets of the buckets are aligned azithmuthally (e.g., along the axis of the chamber) with radial magnetization patterns alternating around the chamber, it is contemplated that the magnetization patterns may be non-alternating. By way of example, the set of magnets may be divided into multiple subsets, each of which may have the same or different number of magnets. This may be appropriate to address any asymmetry issues encountered in a particular chamber. Also, the axes of each magnet may be aligned in a direction other than the radial direction. Again, this implementation may be appropriate to address any asymmetry issues encountered in a particular chamber.

In a particularly advantageous embodiment, some or all of the magnets of the magnetic bucket may be made rotatable on their axes to change the magnetization pattern. One such implementation is shown in Fig. 6C. Alternatively or additionally, the magnitude of individual magnets may be made variable, either by physically moving the magnets or altering the amount of current running through the magnets (if electromagnets are involved, for example).

Further, although the embodiment of Fig. 1 shows the cusps of the magnetic bucket arrangement to be axial, such is not an absolute requirement. By way of example, some or all of the cusps may be formed in a checker board pattern (e.g., Fig. 6A) or azithmuthal pattern (e.g., Fig. 6B) wherein the magnets may be disposed parallel to the plane of the substrate. In some plasma processing systems, these arrangements may be appropriate as they may be able to ensure to a greater degree, due to the specifics of some plasma processing systems, that the plasma density gradients are away from the substrate.

Fig. 7 illustrates, in accordance with one embodiment of the present invention, a simplified flowchart illustrating the steps involved in controlling process uniformity by altering the radial variation of the controlled magnetic field strength and/or topology. In step 702, a single chamber, substantially azithmuthally symmetric plasma processing chamber is provided. The single chamber can be employed to both ignite and sustain the plasma for processing, thereby eliminating the need for a separate plasma generation chamber and plasma transport issues associated therewith.

As noted above, the etching process needs to be tightly controlled to achieve desirable etch characteristics such as selectivity, etch uniformity, etch rate, etch profile, etc. One important consideration in achieving tight control over the etch process is the material utilized for the plasma processing chamber, e.g., the single chamber provided in step 702. More particularly, although undesired, the material of the plasma processing chamber often participates in the etch process. As examples of reactions which are undesirable if left uncontrolled, inner surfaces of a plasma processing chamber may interact with the reactant gases that are used in the plasma processing chamber, or materials such as polymers may stick to inner surfaces of the processing chamber in ways that vary from wafer to wafer or disadvantageously during a single wafer. Dielectric etching processes are used for many applications; often to form self-aligned contacts, high aspect ratio contacts, borderless contacts, vias, trenches etc. by etching through doped or undoped oxides.

Recently a large number of alternative dielectrics have been proposed aimed at reducing the dielectric constant of the material. These are known collectively in the community as low-k materials, e.g., carbon or fluorine doped oxides or organic based materials. Dielectric etching by its nature depends on a very subtle balance between competing reactions on the evolving surface of the wafer, surfaces of the etched features and surfaces of the chamber. These reactions involve plasma species such as ions and electrons, neutral gasses introduced as feed gas, dissociated by plasma excitation or formed via a multitude of physical and chemical processes within the chamber. Due to the nature of these reactions, the area of material facing the plasma and the proximity of the chamber materials to the wafer, the material of the plasma processing chamber is especially important. In addition, since the materials themselves are changing at an ever increasing rate, the exact nature of the required processes are not know ahead of time. This is especially true of difficult processing metrics such as uniformity of etched critical dimension across the wafer. Such metrics often depend on not only the details of the chamber design, but also on the overall system design. Hence, focussing in particular relating to this invention; it is desirable to minimize the extent to which the material of the plasma processing chamber reacts with the etch process to achieve a processing chamber that can meet the requirements of all the etch applications.

Besides minimization of the reactance, the material utilized for the plasma processing chamber should also desirably have moderate to high thermal and electrical conductivity as well as have strong mechanical properties. During various stages of the etching process it is desirable to control the temperature of a plasma processing chamber within a few degrees Celsius. A material that can provide moderate to high thermal conductivity is beneficial since it can facilitate control of the temperature of the plasma processing chamber. A material that can provide moderate to high electrical conductivity is also beneficial because it is beneficial to the repeatability of the chamber. It is also beneficial to provide sufficient ground area for plasma stability and repeatability. Further, a material that has strong mechanical properties is helpful because the material is subjected to harsh environmental conditions (pressure and temperature and maintenance activities). One material with such desirable characteristics is silicon carbide (SiC). SiC is a material with relatively high thermal conductivity and moderate electrical conductivity. In addition, SiC offers good mechanical properties, such as its strength, needed to hold a vacuum in the chamber.

The plasma processing chamber can be made of SiC to facilitate tighter control over the etching process. As will be understood by those skilled in the art, the entire plasma processing chamber may be made from SiC. Alternatively, only inner surfaces of the plasma processing chamber can be made of SiC, e.g., a coating of SiC may be used as will be discussed later. SiC can be made in a variety of ways. It is desirable to use a pure form SiC so that it does not include significant amounts of metal elements. As is known in the art, material containing metal that is exposed to plasma during an etch process can cause metal contamination which adversely effects the etching process. Such contamination of the etching process makes it difficult to clean the plasma processing chamber and/or maintain a uniform sticking coefficient for the material that sticks to the walls of the plasma processing chamber, e.g., polymers. To achieve tight control over the etching process, contamination should be minimized. Hence, SiC is a well suited material for the plasma processing chamber since it is resistant to etching processes and can be made in a pure form. Several methods can be used to produce SiC in a pure form. For example, Chemical Vapor Deposition (CVD), Slipcast Forming, hot-pressed and sintered, Iso-statically-pressed and Sintered Forming can be used to produce SiC in a pure form.

In accordance with a preferred embodiment of the present invention, the plasma processing chamber (e.g., the single chamber of step 702) is made of CVD deposited SiC. CVD technique is preferred because it can produce SiC in an "ultra pure" form. Pure SiC is also etch resistant with respect to plasma processing reactant gas chemistries that are introduced to facilitate the etching processing. Suitable reactant gas chemistries will be discussed below. Given the relative expense associated with producing CVD deposited SiC, other forms of SiC may be more cost effective for some etch process, e.g., non-dielectric etching and/or etching processes where achieving tight control over etching parameters is not an important factor. Alternatively, the SiC can be provided as a coating on another material. For example, SiC can be applied on another material (e.g., aluminum) using flame sprayed coatings or sputter deposited coatings or even CVD SiC coating on another suitable substrate such as Slipcast SiC, graphite or Aluminum. In addition the SiC or other suitable material may be bonded to either a support that is attached to the cylindrical chamber wall or bonded directly to a cylindrical support. This method may have advantages if the desired material for the inner surface of the chamber does not contain all the desired physical properties or may be more cost effectively implemented for example.

SiC can also be made with higher electrical resistivity. As noted above, SiC often has moderate electrical conductivity. However, electrical conductivity of SiC is manageable so that SiC with higher electrical resistivity can be produced. Advantageously, some parts of the plasma processing chamber may be made of SiC material with higher electrical resistivity. By way of example, in plasma processing systems that utilize a Radio Frequency (RF) powered wafer supporting mechanisms, e.g., an electrostatic chuck (ESC), it is desirable to have a wafer supporting mechanism that can offer higher electrical resistivity in order to minimize RF coupling therefrom. As another example, as noted earlier, it is contemplated that coupling window 130 (shown in Fig. 1) may advantageously be formed from either a dielectric material such as SiC, AlₓN_{y} or SiₓN_{y}. Thus, SiC made with higher electrical resistivity can be used to form other parts of the plasma processing system, such as an ESC or a coupling window, where higher electrical resistivity is desirable.

Although SiC has been discussed as a particularly suitable material for the plasma processing chamber (e.g., the single chamber of step 702), other materials may be used for the plasma processing chamber. In addition, other materials besides SiC can be used to produce one or more of the components of a plasma processing system (e.g., ESC or coupling window). By way of example, other suitable materials for the plasma processing chamber or components thereof can include quartz, silicon, silicon dioxide, carbon, boron carbide, boron nitride.

It should also be understood that other material maybe more suitable for some particular etch process. For example, given the relative high cost associated with producing SiC in pure form, other material, e.g., quartz, which is a relatively easy and inexpensive material to produce and thus may be a more suitable alternative for some etching processes where achieving a tight control over the etching parameters has more tolerance. Further, when even greater latitude is available with respect to the tight control the material used within the plasma processing chamber could even use aluminum, or anodized aluminum. Furthermore, as will be apparent to those skilled in the art, configurations that utilize a combination of materials may also be used to make the plasma processing chamber as well as other components of the plasma processing system (e.g., ESC or coupling window).

As noted above, in step 702, a single chamber, substantially azithmuthally symmetric plasma processing chamber is provided. Continuing with the process illustrated in Fig.1, in step 704, the RF antenna is provided. In step 706, the upper magnet arrangement is provided and arranged such that together, the RF antenna and the upper magnet arrangement give rise to a nontrivial radial variation of the controlled magnetic field strength and/or topology which effect control of the processing uniformity at the wafer.

In step 708, the substrate is placed within the plasma processing chamber for processing. In step 710, reactant gases (e.g., deposition source gases, etchant source gases, dilutant gases, etc.) are flown into the plasma processing chamber and a plasma is ignited therefrom. A wide variety of gas chemistries are available for the reactant gases that are flown into the plasma processing. These gas chemistries can be selected for a particular etching processes and/or in consideration of several other factors. Examples of other factors include the material of the plasma processing chamber, type of etch process, or other components of the plasma processing system. Generally speaking, in accordance with an embodiment of the present invention, a combination of gases of the form Cₓ F_{y} H_{z} O_{w} (where, x, y, z and w are integers and where z and/or w can be zero or where y and/or w can be zero) can be used in conjunction with one or more of O₂, N₂, CO, CO₂ and SF₆, NF₃, NH₃, Cl₂ or HBr gases for dielectric etching processes. In addition, other gases can be added to the chemistries noted above, such as He, Ne, Ar, Kr, Xe may be utilized to serve as dilutants or deposition precursors. By way of example, a combination of gases of the form Cₓ F_{y} H_{z} O_{w} can include a Fluorocarbon (CₓF_{y}) and/or Hydrofluorocarbon (CₓH_{y}F_{z}) gas that is combined with a mixture of other gases. Representative combinations of gases that can be used for the reactant gas chemistries are provided in Table 1 below.

| TABLE 1 -REACTANT GAS CHEMISTRIES |
|---|
| C₅F₈ +CF₄+CHF₃+CH₂F₂ |
| C₄F₈ +CF₄+CHF₃+CH₂F₂ |
| C₄F₆ +CF₄+CHF₃+CH₂F₂ |
| C₃F₆ +CF₄+CHF₃+CH₂F₂ |
| C₂F₆ +CF₄+CHF₃+CH₂F₂ |
| C₂ HF₅ +CF₄+CHF₃+CH₂F₂ |
| C₅F₈ +CF₄+CHF₃+C₂H₂F₄ |
| C₄F₈ +CF₄+CHF₃+C₂H₂F₄ |
| C₄F₆ +CF₄+CHF₃+C₂H₂F₄ |
| C₃F₆ +CF₄+CHF₃+C₂H₂F₄ |
| C₂F₆ +CF₄+CHF₃+C₂H₂F₄ |
| C₂HF₅ +CF₄+CHF₃+C₂H₂F₄ |
| C₅F₈ +CHF₃+C₂HF₅+CH₂F₂ |
| C₄F₈ +CHF₃+C₂HF₅+CH₂F₂ |
| C₄F₆ +CHF₃+C₂HF₅+CH₂F₂ |
| C₃F₆ +CHF₃+C₂HF₅+CH₂F₂ |
| C₂F₆ +CHF₃+C₂HF₅+CH₂F₂ |
| CF₄ +CHF₃+C₂HF₅+CH₂F₂ |

As noted earlier, one or more of the O₂, N₂, CO, CO₂ and SF₆ gases can also be provided in the combination of gases used for the reactant gas chemistries. Hence, one or more of O₂, N₂, CO, CO₂ and SF₆ NF₃, NH₃, Cl₂ or HBr can be added to the reactant gas chemistries listed in Table 1. In addition, one or more other gases can be added to form the desired reactant gas chemistries, e.g., gases such as He, Ne, Ar, Kr and Xe may be utilized to serve as dilutants or other gases may be added as deposition precursors. Representative combinations of gases which include these other gases can, for example, result from combining one or more of He, Ne, Ar, Kr and Xe with any of the gas chemistries provided in Table 1.

After the reactant gases are delivered into the plasma processing chamber and a plasma is ignited in step 710, next in step 712, the radial variation of the controlled magnetic field strength and/or topology in the vicinity of the RF antenna is adjusted to a setting that improves processing uniformity across the substrate surface. The setting may be done in advance prior to processing to a predefined setting or may be done in real time to tune the processing uniformity during plasma processing either by fixed setting or with a feedback loop to some process sensitive variable.

As can be appreciated by those skilled in the art, the invention may easily be adapted to control process uniformity in an active, time-dependent manner that allows full control of the wafer processing over a wider processing regime than possible without the uniformity control. By way of example, it is expected that a wider range of plasma density may be employed in the inventive plasma processing system (e.g., about 10⁹ to about 10¹³ ions/cm³) since the magnetic bucket allows the source energy to be utilized very efficiently in the generation and sustaining of the plasma and the upper magnetic arrangement allows process uniformity control to be maintained throughout the plasma density range. Likewise, it is expected that a wider range of pressure (e.g., 133 Pa (<1mT) to about 13.3 KPa (100 mT) may be successfully employed in processing substrates since the magnetic bucket allows the plasma to be sustained at lower pressures. Thus, a single reactor may be employed for different processes having wide process windows, which gives the process engineer a degree of flexibility not available in prior art plasma processing systems.

Furthermore, it is contemplated that an appropriate feedback mechanism may be employed to monitor the process uniformity on a substrate in real time and to modify the radial variation in the controlled magnetic field strength and topology, also in real time, in order to achieve the desired optimum process uniformity result. Alternatively or additionally, the radial variation in the controlled magnetic field strength and topology may be dialed to different settings to achieve the right uniformity control for different etch steps in a given etch process. Note that these settings may be done with or without the benefit of the feedback mechanism, and may be performed either while etching through a single film or as the etch moves from film to film. In the case without the feedback mechanism, the appropriate uniformity settings for the various steps may be ascertained in advance, empirically or otherwise, and employed during etching.

While this invention has been described in terms of several preferred embodiments, there are alterations, which fall within the scope of the claims. By way of example, although etching is employed throughout the preferred embodiment to simplify the discussion, it should be understood that the uniformity control applies to any semiconductor processing process, e.g., deposition.

## Claims

1. A plasma processing system (100) for processing a substrate (122), comprising:
a plasma processing chamber (106) within which a plasma is both ignited and sustained for said processing, said plasma processing chamber having an upper end and a lower end, said plasma processing chamber comprising a material that does not substantially react with reactive gas chemistries that are delivered into said plasma processing chamber;
a coupling window (130,120) disposed at an upper end of said plasma processing chamber.
an RF antenna arrangement (102) disposed above a plane defined by said substrate when said substrate is disposed within said plasma processing chamber for said processing;
**characterized in that** it further comprises
an electromagnet arrangement (104) disposed above said plane defined by said substrate, said electromagnet arrangement being configured so as to result in a radial variation in a controlled magnetic field within said plasma processing chamber in the region proximate said coupling window and antenna when at least one direct current is supplied to said electromagnet arrangement, said radial variation being effective to affect processing uniformity across said substrate; and
a dc power supply (114) coupled to said electromagnet arrangement, said dc power supply having a controller to vary a magnitude of said at least one direct current, thereby changing said radial variation in said controlled magnetic field within said plasma processing chamber in said region proximate said antenna to improve said processing uniformity across said substrate.

2. The plasma processing system of claim 1 wherein said plasma processing chamber includes an inner surface and at least the inner surface of the plasma processing chamber is made of a material that does not substantially interact with reactive gas chemistries that are flown into said plasma processing chamber.

3. The plasma processing system of claim 2 wherein said material of said plasma processing chamber is selected from a group of materials consisting of silicon carbide, quartz, silicon, silicon dioxide, carbon, boron carbide, and boron nitride.

4. The plasma processing system of any preceding claim wherein said plasma processing chamber is entirely made of a material that does not substantially interact with reactive gas chemistries that are delivered into the single chamber.

5. The plasma processing system of claim 4 wherein said material of said plasma processing chamber is selected from a group of materials consisting of silicon carbide, quartz, silicon, silicon dioxide, carbon, boron carbide, and boron nitride.

6. The plasma processing system of any preceding claim wherein said material of said plasma processing chamber is silicon carbide.

7. The plasma processing system of claim 6 wherein the silicon carbide of said plasma processing chamber is selected from a group of materials consisting of Chemical Vapor Deposition (CVD), Slipcast Forming, hot-pressed and sintered, iso-statically-pressed and sintered formed silicon carbide.

8. The plasma processing system of any preceding claim wherein silicon carbide of said plasma processing chamber is Chemical Vapor Deposition (CVD) deposited silicon carbide.

9. The plasma processing system of claim 2 wherein said material of said plasma processing chamber is a coating of material.

10. The plasma processing system of claim 2 wherein said material of said plasma processing chamber is a coating of silicon carbide.

11. The plasma processing system of claim 2 wherein material forming said inner surface of said plasma processing chamber is provided by a bonded assembly consisting of a suitable material bonded the chamber wall.

12. The plasma processing system of claim 11, wherein said bonded assembly is bonded with a electrically conductive or a thermally conductive adhesive.

13. The plasma processing system of claim 11, wherein said bonded assembly is configured to reliably form a significant part of the plasma ground.

14. The plasma processing system of claim 11, wherein said bonded assembly is comprised of several segments or tiles of said suitable material bonded to the chamber wall.

15. The plasma processing of claim 11, wherein said suitable material is silicon carbide.

16. The plasma processing system of claim 2, wherein material forming said inner surface of said plasma processing chamber is a provided by a bonded assembly consisting of a suitable material bonded to a support said support being attached to the chamber wall.

17. The plasma processing system of claim 16, wherein said bonded assembly is bonded with an electrically conductive or a thermally conductive adhesive.

18. The plasma processing system of claim 16, wherein said bonded assembly is configured to reliably form a significant part of plasma ground.

19. The plasma processing system of claim 16, wherein said bonded assembly is comprised of several segments or tiles.

20. The plasma processing system as recited in claim 16, wherein said suitable material is silicon carbide.

21. The plasma processing system of claim 2 further comprising:
a substrate support (124) configured to support said substrate during said processing,
wherein said substrate support forming part of the inner surface of the chamber is made of a material that is more electrically resistant than that of the material of said plasma processing chamber.

22. The plasma processing system of claim 21 wherein said material of said substrate support is selected from a group of materials consisting of silicon carbide, quartz, silicon, silicon dioxide, carbon, boron carbide, boron nitride, and anodized aluminum.

23. The plasma processing system of claim 21 wherein said material of said substrate support is silicon carbide.

24. The plasma processing system of any preceding claim wherein said processing includes etching said substrate.

25. The plasma processing system of any preceding claim wherein said coupling window has at least one surface made of silicon carbide.

26. A method for controlling processing uniformity while processing a substrate (122) using a plasma-enhanced process, comprising:
providing a plasma processing chamber (106) having a single chamber, substantially azithmuthally symmetric configuration within which a plasma is both ignited and sustained during said processing of said substrate, said plasma processing chamber having no separate plasma generation chamber;
providing a coupling window (130, 120) disposed at an upper end of said plasma processing chamber;
providing an RF antenna arrangement (102) disposed above a plane defined by said substrate when said substrate is disposed within said plasma processing chamber for said processing;
providing an electromagnet arrangement (104) disposed above said plane defined by said substrate, said electromagnet arrangement being configured so as to result in a radial variation in the controlled magnetic field within said plasma processing chamber in the region proximate said coupling window and antenna when at least one direct current is supplied to said electromagnet arrangement, said radial variation being effective to affect processing uniformity across said substrate;
providing a dc power supply (114) coupled to said electromagnet arrangement;
placing said substrate into said plasma processing chamber;
flowing reactant gases into said plasma processing chamber, said reactant gases include a combination of gases, wherein one or more gases of said combination of gases included in said reactant gases is a Cₓ F_{y} H_{z} O_{w} gas, and wherein x, y, z, and w are positive integers though any of z, w, and y can be zero;
striking said plasma out of said reactant gases; and
changing said radial variation in said controlled magnetic field within said plasma processing chamber in said region proximate to said antenna to improve said processing uniformity across said substrate.

27. The method of claim 26 wherein the reactant gases further include one or more gases selected from a group of gases consisting of O₂, N₂, CO, CO₂, SF₆, NF₃, NH₃, Cl₂ and HBr.

28. The method of claim 27 herein the reactant gases further include one or more gases selected from a group of gases consisting of He, Ne, Ar, Kr and Xe.

29. The method of claim 26 wherein the reactant gases further include one or more gases selected from a group of gases consisting of He, Ne, Ar, Kr and Xe.

30. The method of claim 26 wherein the reactant gases include a gas that is selected from a group of gases consisting of C₅F₈, C₄F₈, C₄F₆, C₃F₆, C₂F₆ and CF₄.

31. The method of claim 26 wherein the reactant gases include a gas that is selected from a group of gases consisting of C₂HF₈, C₂HF₅, CHF₃, C₂H₂F₂, C₂H₂F₄ and CH₂F₂.

32. The method of claim 26 wherein the reactant gases include a gas that is selected from a group of gases consisting of: ;
C₅F₈ +CF₄+CHF₃+CH₂F₂;
C₄F₈ +CF₄+CHF₃+CH₂F₂;
C₄F₆ +CF₄+CHF₃+CH₂F₂;
C₃F₆ +CF₄+CHF₃+CH₂F₂;
C₂F₆ +CF₄+CHF₃+CH₂F₂;
C₂HF₅ +CF₄+CHF₃+CH₂F₂;
C₅F₈ +CF₄+CHF₃+C₂H₂F₄;
C₄F₈ +CF₄+CHF₃+C₂H₂F₄;
C₄F₆ +CF₄+CHF₃+C₂H₂F₄;
C₃F₆ +CF₄+CHF₃+C₂H₂F₄;
C₂F₆ +CF₄+CHF₃+C₂H₂F₄;
C₂ HF₅ +CF₄+CBF₃+C₂H₂F₄;
C₅F₈ +CHF₃+C₂HF₅+CH₂F₂;
C₄F₈ +CHF₃+C₂HF₅+CH₂F₂;
C₄F₆ +CHF₃+C₂HF₅+CH₂F₂;
C₃F₆ +CHF₃+C₂HF₅+CH₂F₂;
C₂F₆ +CHF₃+C₂HF₅+CH₂F₂;
and
CF₄ +CHF₃+C₂HF₅+CH₂F₂.

33. The method of claim 32 wherein the reactant gases further include one or more gases selected from a group of gases consisting of O₂, N₂, CO, CO₂ and SF₆.

34. The method of claim 33, wherein the reactant gases further include one or more gases selected from a group of gases consisting of He, Ne, Ar, Kr and Xe.

35. The method of claim 32, wherein the reactant gases further include one or more gases selected from a group of gases consisting of O₂, N₂, CO, CO₂ NF₃, NH₃, Ch or HBr and SF₆.

36. The method of claim 32, wherein the reactant gases further include one or more gases selected from a group of gases consisting of He, Ne, Ar, Kr and Xe.

37. The method of claim 26 wherein said plasma processing chamber includes an inner surface and at least the inner surface of the plasma processing chamber is made of a material that does not substantially interact with reactive gas chemistries that are flown into said plasma processing chamber.

38. The method of claim 37 wherein said material of said plasma processing chamber is selected from a group of materials consisting of silicon carbide, quartz, silicon, silicon dioxide, carbon, boron carbide, and boron nitride

39. The method of claim 31, wherein said plasma processing chamber includes silicon carbide.

40. The method of claim 26 wherein said plasma processing chamber is made entirely of silicon carbide.

41. The plasma processing system of claim 1 wherein reactant gases are flown into said plasma processing chamber, said reactant gases including a combination of gases wherein one or more gases of said combination of gases included in said reactant gases is a Cₓ F_{y} H_{z} O_{w} gas, and wherein x, y, z, and w are positive integers, and at least one of z and w can be zero, or at least one of y and w can be zero.

42. The plasma processing system of claim 41 wherein said reactant gases further include one or more gases selected from a group of gases consisting of O₂, N₂, CO, CO₂ NF₃, NH₃, Cl₂, HBr and SF₆.

43. The method of claim 41 wherein said reactant gases further include one or more gases selected from a group of gases consisting of He, Ne, Ar, Kr and Xe.

## Patentansprüche

1. Eine Plasmabearbeitungsvorrichtung (100) zum Bearbeiten eines Substrats (122), die aufweist:
eine Plasmabearbeitungskammer (106), innerhalb der ein Plasma zum Bearbeiten sowohl entzündet als auch gehalten wird, wobei die Plasmabearbeitungskammer ein oberes Ende und ein unteres Ende aufweist, und wobei die Plasmabearbeitungskammer ein Material aufweist, das im wesentlichen nicht mit reaktiver Gas-Chemie (gas chemistries), die in die Plasmabearbeitungskammer zugeführt werden, reagiert,
ein Koppelfenster (130, 120), das an einem oberen Ende der Plasmabearbeitungskammer angeordnet ist,
eine RF-Antennenanordnung (102), die oberhalb einer durch das Substrat definierten Ebene angeordnet ist, wenn das Substrat für die Bearbeitung innerhalb der Plasmabearbeitungskammer angeordnet ist;
**dadurch gekennzeichnet, dass** sie ferner aufweist:
eine Elektromagnet-Anordnung (104), die oberhalb der durch das Substrat definierten Ebene angeordnet ist, wobei die Elektromagnet-Anordnung derart konfiguriert ist, dass sie in einem Bereich nahe des Koppelfensters und der Antenne innerhalb der Plasmabearbeitungskammer zu einer Radialveränderung in einem gesteuerten Magnetfeld führt, wenn mindestens ein Gleichstrom der Elektromagnet-Anordnung zugeführt wird, wobei sich die Radialveränderung wirksam auf die Bearbeitungshomogenität über das Substrat auswirkt, und
ein Gleichstromnetzteil (114), das mit der Elektromagnet-Anordnung gekoppelt ist, wobei das Gleichstromnetzteil einen Regler aufweist zum Verändern einer Größe von dem mindestens einem Gleichstrom aufweist, wodurch die Radialveränderung in dem gesteuerten Magnetfeld innerhalb der Plasmabearbeitungskammer im Bereich nahe der Antenne verändert wird, um die Bearbeitungshomogenität über das Substrat zu verbessern.

2. Plasmabearbeitungsvorrichtung nach Anspruch 1, wobei die Plasmabearbeitungskammer eine Innenoberfläche beinhaltet, und dass mindestens die Innenoberfläche der Plasmabearbeitungskammer aus einem Material gefertigt ist, das nicht wesentlich mit reaktiver Gas-Chemie (gas chemistries), die in die Plasmabearbeitungskammer eingeströmt sind, zusammenwirkt.

3. Plasmabearbeitungsvorrichtung nach Anspruch 2, wobei das Material der Plasmabearbeitungskammer aus einer Materialgruppe ausgewählt wird, die aus Siliziumkarbid, Quarz, Silizium, Siliziumdioxid, Kohlenstoff, Borkarbid und Bornitrid besteht.

4. Plasmabearbeitungsvorrichtung nach einem der vorhergehenden Ansprüche, wobei die Plasmabearbeitungskammer vollständig aus einem Material gefertigt ist, das nicht wesentlich mit reaktiver Gas-Chemie (gas chemistries), die in die Einzelkammer zugeführt werden, zusammenwirkt.

5. Plasmabearbeitungsvorrichtung nach Anspruch 4, wobei das Material der Plasmabearbeitungskammer aus einer Materialgruppe ausgewählt wird, die aus Siliziumkarbid, Quarz, Silizium, Siliziumdioxid, Kohlenstoff, Borkarbid und Bornitrid besteht.

6. Plasmabearbeitungsvorrichtung nach einem der vorhergehenden Ansprüche, wobei das Material der Plasmabearbeitungskammer Siliziumkarbid ist.

7. Plasmabearbeitungsvorrichtung nach Anspruch 6, wobei das Siliziumkarbid der Plasmabearbeitungskammer aus einer Materialgruppe ausgewählt wird, die aus Gasphasenabscheidung-(CVD), Schlickergussausformung-, heißgepressten und gesinterten, isostatisch gepressten und gesinterten ausgebildetem Siliziumkarbid besteht.

8. Plasmabearbeitungsvorrichtung nach einem der vorhergehenden Ansprüche, wobei das Siliziumkarbid der Plasmabearbeitungskammer ein durch Gasphasenabscheidung abgeschiedenes Siliziumkarbid ist.

9. Plasmabearbeitungsvorrichtung nach Anspruch 2, wobei das Material der Plasmabearbeitungskammer ein Überzugsmaterial ist.

10. Plasmabearbeitungsvorrichtung nach Anspruch 2, wobei das Material der Plasmabearbeitungskammer ein Überzug aus Siliziumkarbid ist.

11. Plasmabearbeitungsvorrichtung nach Anspruch 2, wobei das Material, das die Innenoberfläche der Plasmabearbeitungskammer ausformt, durch einen verbundenen Aufbau vorgesehen ist, der aus einem geeigneten Material besteht, das mit der Kammerwand verbunden ist.

12. Plasmabearbeitungsvorrichtung nach Anspruch 11, wobei der verbundene Aufbau durch einen elektrisch leitenden oder einen wärmeleitenden Kleber verbunden ist.

13. Plasmabearbeitungsvorrichtung nach Anspruch 11, wobei der verbundene Aufbau derart konfiguriert ist, um zuverlässig einen signifikanten Teil des Plasmabodens auszubilden.

14. Plasmabearbeitungsvorrichtung nach Anspruch 11, wobei der verbundene Aufbau aus mehreren Segmenten oder Fliesen des geeigneten Materials, das mit der Kammerwand verbunden ist, besteht.

15. Plasmabearbeitung nach Anspruch 11, wobei das geeignete Material Siliziumkarbid ist.

16. Plasmabearbeitungsvorrichtung nach Anspruch 2, wobei das Material, das die Innenoberfläche der Plasmabearbeitungskammer ausbildet, durch einen verbundenen Aufbau vorgesehen ist, der aus einem geeigneten Material besteht, das mit einem Träger verbunden ist, wobei der Träger an der Kammerwand angebracht ist.

17. Plasmabearbeitungsvorrichtung nach Anspruch 16, wobei der verbundene Aufbau durch einen elektrisch leitenden oder einen wärmeleitenden Kleber verbunden ist.

18. Plasmabearbeitungsvorrichtung nach Anspruch 16, wobei der verbundene Aufbau derart konfiguriert ist, um zuverlässig einen signifikanten Teil des Plasmabodens auszubilden.

19. Plasmabearbeitungsvorrichtung nach Anspruch 16, wobei der verbundene Aufbau aus mehreren Segmenten oder Fliesen besteht.

20. Plasmabearbeitungsvorrichtung nach Anspruch 16, wobei das geeignete Material Siliziumkarbid ist.

21. Plasmabearbeitungsvorrichtung nach Anspruch 2, ferner aufweisend:
einen Substratträger (124) der derart konfiguriert ist, um während des Bearbeitens das Substrat zu tragen, wobei der Substratträger, der einen Teil der Innenoberfläche der Kammer ausbildet, aus einem Material gefertigt ist, das einen höheren elektrischen Widerstand hat als das Material der Plasmabearbeitungskammer.

22. Plasmabearbeitungsvorrichtung nach Anspruch 21, wobei das Material des Substratträgers aus einer Materialgruppe ausgewählt wird, die aus Siliziumkarbid, Quarz, Silizium, Siliziumdioxid, Kohlenstoff, Borkarbid, Bornitrid und eloxiertem Aluminium besteht.

23. Plasmabearbeitungsvorrichtung nach Anspruch 21, wobei das Material des Substratträgers Siliziumkarbid ist.

24. Plasmabearbeitungsvorrichtung nach einem der vorhergehenden Ansprüche, wobei das Bearbeiten ein Ätzen des Substrats beinhaltet.

25. Plasmabearbeitungsvorrichtung nach einem der vorhergehenden Ansprüche, wobei das Koppelfenster mindestens eine Oberfläche aufweist, die aus Siliziumkarbid gefertigt ist.

26. Verfahren zum Steuern einer Bearbeitungshomogenität während des Bearbeitens eines Substrats (122) unter Verwendung einer verbesserten Plasmabearbeitung, aufweisend:
Vorsehen einer Plasmabearbeitungskammer (106), die eine Einzelkammer mit einer im wesentlichen azimuthalen symmetrischen Anordnung aufweist, innerhalb der ein Plasma während des Bearbeitens des Substrats sowohl gezündet als auch gehalten wird, wobei die Plasmabearbeitungskammer keine separate Plasmaerzeugungskammer aufweist;
Vorsehen eines Koppelfensters (130, 120), das an einem oberen Ende der Plasmabearbeitungskammer angeordnet ist,
Vorsehen einer RF-Antennenanordnung (102), die oberhalb einer durch das Substrat definierten Ebene angeordnet ist, wenn das Substrat für das Bearbeiten innerhalb der Plasmabearbeitungskammer angeordnet ist;
Vorsehen einer Elektromagnet-Anordnung (104), die oberhalb der durch das Substrat definierten Ebene angeordnet ist, wobei die Elektromagnet-Anordnung derart konfiguriert ist, so dass sie im Bereich nahe des Koppelfensters und der Antenne innerhalb der Plasmabearbeitungskammer zu einer Radialveränderung in dem gesteuerten Magnetfeld führt, wenn der Elektromagnet-Anordnung mindestens ein Gleichstrom zugeführt wird, wobei sich die Radialveränderung wirksam auf die Bearbeitungshomogenität über das Substrat auswirkt;
Vorsehen eines Gleichstromnetzteils (114), das mit der Elektromagnet-Anordnung gekoppelt ist;
Anordnen des Substrats in die Plasmabearbeitungskammer;
Einströmen von Reaktionspartner-Gasen in die Plasmabearbeitungskammer, wobei die Reaktionspartner-Gase eine Gaskombination beinhalten, bei der ein oder mehrere Gase dieser Gaskombination, die in den Reaktionspartner-Gasen beinhaltet sind, ein CₓF_{y}H_{z}O_{w} Gas ist, und wobei x, y, z und w positive Ganzzahlen sind, obgleich z, w und y beliebig Null werden können;
Zünden des Plasmas in den gasförmigen Reaktionspartnern; und
Verändern der Radialveränderung im gesteuerten Magnetfeld innerhalb der Plasmabearbeitungskammer im bereich nahe der Antenne, um die Bearbeitungshomogenität über das Substrat zu verbessern.

27. Verfahren nach Anspruch 26, wobei die Reaktionspartner-Gase ferner ein oder mehrere Gase beinhalten, die aus einer Gasgruppe ausgewählt werden, die aus O₂, N₂, CO, CO₂, SF₆, NF₃, NH₃, Cl₂ und HBr besteht.

28. Verfahren nach Anspruch 27, wobei die Reaktionspartner-Gase ferner ein oder mehrere Gase beinhalten, die aus einer Gasgruppe ausgewählt werden, die aus He, Ne, Ar, Kr und Xe besteht.

29. Verfahren nach Anspruch 26, wobei die Reaktionspartner-Gase ferner ein oder mehrere Gase beinhalten, die aus einer Gasgruppe ausgewählt werden, die aus He, Ne, Ar, Kr und Xe besteht.

30. Verfahren nach Anspruch 26, wobei die Reaktionspartner-Gase ein Gas beinhalten, das aus einer Gasgruppe ausgewählt wird, die aus C₅F₈, C₄F₈, C₉F₆, C₃F₆, C₂F₆ und CF₄ besteht.

31. Verfahren nach Anspruch 26, wobei die Reaktionspartner-Gase ein Gas beinhalten, das aus einer Gasgruppe ausgewählt wird, die aus C₂HF₈, C₂HF₅, CHF₃, C₂H₂F₂, C₂H₂F₄ und CH₂F₂ besteht.

32. Verfahren nach Anspruch 26, wobei die Reaktionspartner-Gase ein Gas beinhalten, das aus einer Gasgruppe ausgewählt wird, die aus
C₅F₈+CF₄+CHF₃+CH₂F₂;
C4F₈+CF₄+CHF₃+CH₂F₂;
C₄F₆+CF₄+CHF₃+CH₂F₂;
C₃F₆+CF₄+CHF₃+CH₂F₂;
C₂F₆+CF₄+CHF₃+CH₂F₂:
C₂HF₅+CF₄+CHF₃+CH₂F₂;
C₅F₈+CF₄+CHF₃+C₂H₂F₄;
C₄F₈+CF₄+CHF₃+C₂H₂F₄;
C₄F₆+CF₄+CHF₃+C₂H₂F₄;
C₃F₆+CF₄+CHF₃+C₂H₂F₄;
C₂F₆+CF₄+CHF₃+C₂H₂F₄;
C₂HF₅+CF₄+CHF₃+C₂H₂F₄;
C₅F₈+CHF₃+C₂HF₅+CH₂F₂,
C₄F₈+CHF₃+C₂HF₅+CH₂F₂;
C₄F₆+CHF₃+C₂HF₅+CH₂F₂;
C₃F₆+CHF₃+C₂HF₅+CH₂F₂;
C₂F₆+CHF₃+C₂HF₅+CH₂F₂;
und
CF₄+CHF₃+C₂HF₅+CH₂F₂
besteht.

33. Verfahren nach Anspruch 32, wobei die Reaktionspartner-Gase ferner ein oder mehrere Gase beinhalten, die aus einer Gasgruppe ausgewählt werden, die aus O₂, N₂, CO, CO₂ und SF₆ besteht.

34. Verfahren nach Anspruch 33, wobei die Reaktionspartner-Gase ferner ein oder mehrere Gase beinhalten, die aus einer Gasgruppe ausgewählt werden, die aus: He, Ne, Ar, Kr und Xe besteht.

35. Verfahren nach Anspruch 32, wobei die Reaktionspartner-Gase ferner ein oder mehrere Gase beinhalten, die aus einer Gasgruppe ausgewählt werden, die aus O₂, N₂, CO, CO₂NF₃, NH₃, Cl₂ oder HBr und SF₆ besteht.

36. Verfahren nach Anspruch 32, wobei die Reaktionspartner-Gase ferner ein oder mehrere Gase beinhalten, die aus einer Gasgruppe ausgewählt werden, die aus He, Ne, Ar, Kr und Xe besteht.

37. Verfahren nach Anspruch 26, wobei die Plasmabearbeitungskammer eine Innenoberfläche beinhaltet und dass mindestens die Innenoberfläche der Plasmabearbeitungskammer aus einem Material gefertigt wird, das nicht wesentlich mit reaktiver Gas-Chemie (gas chemistries), die in die Plasmabearbeitungskammer eingeströmt sind, zusammenwirkt.

38. Verfahren nach Anspruch 37, wobei das Material der Plasmabearbeitungskammer aus einer Materialgruppe ausgewählt wird, die aus Siliziumkarbid, Quarz, Silizium, Siliziumdioxid, Kohlenstoff, Borkarbid und Bornitrid besteht.

39. Verfahren nach Anspruch 31, wobei die Plasmabearbeitungskammer Siliziumkarbid beinhaltet.

40. Verfahren nach Anspruch 26, wobei die Plasmabearbeitungskammer vollständig aus Siliziumkarbid gefertigt wird.

41. Plasmabearbeitungsvorrichtung nach Anspruch 1, wobei Reaktionspartner-Gase in die Plasmabearbeitungskammer einströmen, wobei die Reaktionspartner-Gase eine Gaskombination beinhalten, bei der ein oder mehrere Gase dieser Gaskombination, die in den Reaktionspartner-Gasen beinhaltet sind, ein CₓF_{y}H_{z}O_{w}-Gas ist und wobei x, y, z und w positive Ganzzahlen sind und mindestens z und w Null werden können, oder mindestens y und w Null werden können.

42. Plasmabearbeitungsvorrichtung nach Anspruch 41, wobei Reaktionspartner-Gase ferner ein oder mehrere Gase beinhalten, die aus einer Gasgruppe ausgewählt werden, die aus O₂, N₂, CO, CO₂NF₃, NH₃, Cl₂ oder HBr und SF₆ besteht.

43. Verfahren nach Anspruch 41, wobei die Reaktionspartner-Gase ferner ein oder mehrere Gase beinhalten, die aus einer Gasgruppe ausgewählt werden, die aus He, Ne, Ar, Kr und Xe besteht.

## Revendications

1. Système de traitement au plasma (100) pour traiter un substrat (122), comprenant :
une chambre de traitement au plasma (106) dans laquelle un plasma est à la fois allumé et maintenu pour ledit traitement, ladite chambre de traitement au plasma comportant une extrémité supérieure et une extrémité inférieure, ladite chambre de traitement au plasma comprenant un matériau qui ne réagit sensiblement pas avec les formulations chimiques gazeuses réactives qui sont délivrées dans ladite chambre de traitement au plasma;
une fenêtre de couplage (130, 120) disposée au niveau d'une extrémité supérieure de ladite chambre de traitement au plasma;
un agencement d'antenne RF (102) disposé au-dessus d'un plan défini par ledit substrat lorsque ledit substrat est disposé dans ladite chambre de traitement au plasma pour ledit traitement ;
**caractérisé en ce qu'**il comprend en outre
un agencement d'électroaimant (104) disposé au-dessus dudit plan défini par ledit substrat, ledit agencement d'électroaimant étant configuré pour aboutir à une variation radiale d'un champ magnétique régulé dans ladite chambre de traitement au plasma dans la région située à proximité de ladite fenêtre de couplage et de l'antenne lorsqu'au moins un courant direct est fourni audit agencement d'électroaimant, ladite variation radiale étant efficace pour affecter l'uniformité de traitement d'un bout à l'autre dudit substrat ; et
une alimentation en courant direct (114) couplée audit agencement d'électroaimant, ladite alimentation en courant direct comportant un dispositif de commande pour faire varier une ampleur dudit au moins un courant direct, modifiant ainsi la variation radiale dudit champ magnétique régulé dans ladite chambre de traitement au plasma dans ladite région située à proximité de ladite antenne pour améliorer ladite uniformité de traitement d'un bout à l'autre dudit substrat.

2. Système de traitement au plasma selon la revendication 1, dans lequel ladite chambre de traitement au plasma comprend une surface interne et au moins la surface interne de la chambre de traitement au plasma est constituée d'un matériau qui n'interagit sensiblement pas avec les formulations chimiques gazeuses réactives qui sont mises en circulation dans ladite chambre de traitement au plasma.

3. Système de traitement au plasma selon la revendication 2, dans lequel ledit matériau de ladite chambre de traitement au plasma est choisi dans un groupe de matériaux constitué par le carbure de silicium, le quartz, le silicium, le dioxyde de silicium, le carbone, le carbure de bore et le nitrure de bore.

4. Système de traitement au plasma selon l'une quelconque des revendications précédentes, dans lequel ladite chambre de traitement au plasma est entièrement constituée d'un matériau qui n'interagit sensiblement pas avec les formulations chimiques gazeuses réactives qui sont délivrées dans la chambre unique.

5. Système de traitement au plasma selon la revendication 4, dans lequel ledit matériau de ladite chambre de traitement au plasma est choisi dans un groupe de matériaux constitué par le carbure de silicium, le quartz, le silicium, le dioxyde de silicium, le carbone, le carbure de bore et le nitrure de bore.

6. Système de traitement au plasma selon l'une quelconque des revendications précédentes, dans lequel ledit matériau de ladite chambre de traitement au plasma est le carbure de silicium.

7. Système de traitement au plasma selon la revendication 6, dans lequel le carbure de silicium de ladite chambre de traitement au plasma est choisi dans un groupe de matériaux constitué par le carbure de silicium formé par dépôt chimique en phase vapeur (CVD), le carbure de silicium formé par coulée en barbotine, le carbure de silicium formé par pressage à chaud et par frittage ainsi que le carbure de silicium formé par pressage isostatique et frittage.

8. Système de traitement au plasma selon l'une quelconque des revendications précédentes, dans lequel le carbure de silicium de ladite chambre de traitement au plasma est un carbure de silicium déposé par dépôt chimique en phase vapeur (CVD).

9. Système de traitement au plasma selon la revendication 2, dans lequel ledit matériau de ladite chambre de traitement au plasma est un revêtement de matériau.

10. Système de traitement au plasma selon la revendication 2, dans lequel ledit matériau de ladite chambre de traitement au plasma est un revêtement de carbure de silicium.

11. Système de traitement au plasma selon la revendication 2, dans lequel le matériau formant ladite surface interne de ladite chambre de traitement au plasma est formé par un ensemble lié constitué d'un matériau approprié lié à la paroi de chambre.

12. Système de traitement au plasma selon la revendication 11, dans lequel ledit ensemble lié est lié avec un adhésif électriquement conducteur ou thermiquement conducteur.

13. Système de traitement au plasma selon la revendication 11, dans lequel ledit ensemble lié est configuré pour former de manière fiable une partie significative de la base de plasma.

14. Système de traitement au plasma selon la revendication 11, dans lequel ledit ensemble lié est composé de plusieurs segments ou carreaux dudit matériau approprié lié à la paroi de chambre.

15. Système de traitement au plasma selon la revendication 11, dans lequel ledit matériau approprié est le carbure de silicium.

16. Système de traitement au plasma selon la revendication 2, dans lequel le matériau formant ladite surface interne de ladite chambre de traitement au plasma est formé par un ensemble lié constitué d'un matériau approprié lié à un support, ledit support étant fixé à la paroi de chambre.

17. Système de traitement au plasma selon la revendication 16, dans lequel ledit ensemble lié est lié avec un adhésif électriquement conducteur ou thermiquement conducteur.

18. Système de traitement au plasma selon la revendication 16, dans lequel ledit ensemble lié est configuré pour former de manière fiable une partie significative de la base de plasma.

19. Système de traitement au plasma selon la revendication 16, dans lequel ledit ensemble lié est composé de plusieurs segments ou carreaux.

20. Système de traitement au plasma selon la revendication 16, dans lequel ledit matériau approprié est le carbure de silicium.

21. Système de traitement au plasma selon la revendication 2, comprenant en outre :
un support de substrat (124) configuré pour soutenir ledit substrat pendant ledit traitement, dans lequel ledit support de substrat faisant partie de la surface interne de la chambre est constitué d'un matériau plus résistant électriquement que le matériau de ladite chambre de traitement au plasma.

22. Système de traitement au plasma selon la revendication 21, dans lequel ledit matériau dudit support de substrat est sélectionné dans un groupe de matériaux constitué par le carbure de silicium, le quartz, le silicium, le dioxyde de silicium, le carbone, le carbure de bore et l'aluminium oxydé anodiquement.

23. Système de traitement au plasma selon la revendication 21, dans lequel ledit matériau dudit support de substrat est le carbure de silicium.

24. Système de traitement au plasma selon l'une quelconque des revendications précédentes, dans lequel ledit traitement comprend la gravure dudit substrat.

25. Système de traitement au plasma selon l'une quelconque des revendications précédentes, dans lequel ladite fenêtre de couplage présente au moins une surface constituée de carbure de silicium.

26. Procédé de régulation de l'uniformité de traitement pendant le traitement d'un substrat (122) à l'aide d'un procédé renforcé au plasma, comprenant :
la fourniture d'une chambre de traitement au plasma (106) comportant une seule chambre, en une configuration sensiblement symétrique azimutalement dans laquelle un plasma est à la fois allumé et maintenu pendant ledit traitement dudit substrat, ladite chambre de traitement au plasma ne comportant pas de chambre de génération de plasma séparée;
la fourniture d'une fenêtre de couplage (130, 120) disposée au niveau d'une extérieure supérieure de ladite chambre de traitement au plasma;
la fourniture d'un agencement d'antenne RF (102) disposé au-dessus d'un plan défini par ledit substrat lorsque ledit substrat est disposé dans ladite chambre de traitement au plasma pour ledit traitement ;
la fourniture d'un agencement d'électroaimant (104) disposé au-dessus dudit plan défini par ledit substrat, ledit agencement d'électroaimant étant configuré pour aboutir à une variation radiale du champ magnétique régulé dans ladite chambre de traitement au plasma dans la région située à proximité de ladite fenêtre de couplage et de l'antenne lorsqu'au moins un courant direct est fourni audit agencement d'électroaimant, ladite variation radiale étant efficace pour affecter l'uniformité de traitement d'un bout à l'autre dudit substrat ;
la fourniture d'une alimentation en courant direct (114) couplée audit agencement d'électroaimant ;
la mise en place dudit substrat dans ladite chambre de traitement au plasma ;
la mise en circulation de gaz réactifs dans ladite chambre de traitement au plasma, lesdits gaz réactifs comprenant une combinaison de gaz, un ou plusieurs gaz de ladite combinaison de gaz inclus dans lesdits gaz réactifs étant un gaz Cₓ F_{y} H_{z} O_{w} et x, y, z et w étant des entiers positifs bien que l'un quelconque de z, w et y puisse être zéro;
le retrait dudit plasma desdits gaz réactifs ; et
la modification de ladite variation radiale dudit champ magnétique régulé dans ladite chambre de traitement au plasma dans ladite région située à proximité de ladite antenne pour améliorer ladite uniformité de traitement d'un bout à l'autre dudit substrat.

27. Procédé selon la revendication 26, dans lequel les gaz réactifs comprennent en outre un ou plusieurs gaz choisis dans un groupe de gaz constitué par O₂, N₂, CO, CO₂, SF₆, NF₃, NH3, Cl₂ et HBr.

28. Procédé selon la revendication 27, dans lequel les gaz réactifs comprennent en outre un ou plusieurs gaz choisis dans un groupe de gaz constitué par He, Ne, Ar, Kr et Xe.

29. Procédé selon la revendication 26, dans lequel les gaz réactifs comprennent en outre un ou plusieurs gaz choisis dans un groupe de gaz constitué par He, Ne, Ar, Kr et Xe.

30. Procédé selon la revendication 26, dans lequel les gaz réactifs comprennent un gaz choisi dans un groupe de gaz constitué par C₅F₈, C₄F₈, C₄F6, C₃F₆, C₂F₆ et CF₄.

31. Procédé selon la revendication 26, dans lequel les gaz réactifs comprennent un gaz choisi dans un groupe de gaz constitué par C₂HF₈, C₂HF₅, CHF₃, C₂H₂F₂, C₂H₂F₄ et CH₂F₂.

32. Procédé selon la revendication 26, dans lequel les gaz réactifs comprennent un gaz choisi dans un groupe de gaz constitué par :
C₆F₈+CF₄+CHF₃+CH₂F₂ ;
C₄F₈+CF₄+CHF₃+CH₂F₂ ;
C₄F₆+CF₄+CHF₃+CH₂F₂ ;
C₃F₆+CF₄+CHF₃+CH₂F₂ ;
C₂F₆+CF₄+CHF₃+CH₂F₂ ;
C₂HF₅+CF₄+CHF₃+CH₂F₂
C₅F₈+CF₄+CHF₃+C₂H₂F₄;
C₄F₈+CF₄+CHF₃+C₂H₂F₄;
C₄F₆+CF₄+CHF₃+C₂H₂F₄ ;
C₃F₆+CF₄+CHF₃+C₂H₂F₄ :
C₂F₆+CF₄+CHF₃+C₂H₂F₄ ;
C₂HF₅+CF₄+CHF₃+C₂H₂F₄ ;
C₅F₈+CHF₃+C₂HF₅+CH₂F₂ ;
C₄F₈+CHF₃+C₂HF₅+CH₂F₂ ;
C₄F₆+CHF₃+C₂HFS+CH₂F₂ ;
C₃F₆+CHF₃+C₂HF₅+CH₂F₂ ;
C₂F₆+CHF₃+C₂HF₅+CH₂F₂ ;
et
CF₄+CHF₃+C₂HF₅+CH₂F₂.

33. Procédé selon la revendication 32, dans lequel les gaz réactifs comprennent en outre un ou plusieurs gaz choisis dans un groupe de gaz constitué par O₂, N₂, CO, CO₂ et SF₆.

34. Procédé selon la revendication 33, dans lequel les gaz réactifs comprennent en outre un ou plusieurs gaz choisis dans un groupe de gaz constitué par He, Ne, Ar, Kr et Xe.

35. Procédé selon la revendication 32, dans lequel les gaz réactifs comprennent en outre un ou plusieurs gaz choisis dans un groupe de gaz constitué par O₂, N₂, CO, CO₂, NF₃, NH₃, Cl₂ ou HBr et SF₆.

36. Procédé selon la revendication 32, dans lequel les gaz réactifs comprennent en outre un ou plusieurs gaz choisis dans un groupe de gaz constitué par He, Ne, Ar, Kr et Xe.

37. Procédé selon la revendication 26, dans lequel ladite chambre de traitement au plasma comprend une surface interne et au moins la surface interne de la chambre de traitement au plasma est constituée d'un matériau qui n'interagit sensiblement pas avec les formulations chimiques gazeuses réactives mises en circulation dans ladite chambre de traitement au plasma.

38. Procédé selon la revendication 37, dans lequel ledit matériau de ladite chambre de traitement au plasma est choisi dans un groupe de matériaux constitué par le carbure de silicium, le quartz, le silicium, le dioxyde de silicium, le carbone, le carbure de bore et le nitrure de bore.

39. Procédé selon la revendication 31, dans lequel ladite chambre de traitement au plasma comprend du carbure de silicium.

40. Procédé selon la revendication 26, dans lequel ladite chambre de traitement au plasma est entièrement constituée de carbure de silicium.

41. Système de traitement au plasma selon la revendication 1, dans lequel des gaz réactifs sont mis en circulation dans ladite chambre de traitement au plasma, lesdits gaz réactifs comprenant une combinaison de gaz, un ou plusieurs gaz de ladite combinaison de gaz inclus dans lesdits gaz réactifs étant un gaz Cₓ F_{y} H_{z} O_{w} et x, y, z et w étant des entiers positifs, et au moins l'un de z et w pouvant être zéro, ou au moins l'un de y et w pouvant être zéro.

42. Système de traitement au plasma selon la revendication 41, dans lequel lesdits gaz réactifs comprennent en outre un ou plusieurs gaz choisis dans un groupe de gaz constitué par O₂, N₂, CO, CO₂, NF₃, NH₃, Cl₂ ou HBr et SF6.

43. Procédé selon la revendication 41, dans lequel lesdits gaz réactifs comprennent en outre un ou plusieurs gaz choisis dans un groupe de gaz constitué par He, Ne, Ar, Kr et Xe.
